# EUROPEAN PATENT APPLICATION

(11) **EP 4 782 864 A1**
(43) Date of publication of application: **29.07.2026**
(21) Application number: 26154824.2
(22) Date of filing: 28.01.2026
(51) Int. Cl.: G01R 33/48, G01R 33/56, G01R 33/565, G01R 33/561

(54) **MAGNETIC RESONANCE IMAGING APPARATUS, IMAGE PROCESSING APPARATUS, IMAGE PROCESSING METHOD, AND PROGRAM**

(30) Priority: 28.01.2025 JP 2025012497
(71) Applicant: FUJIFILM Corporation, Tokyo 106-8620 (JP)
(72) Inventor: SUZUKI, Atsuro, Tokyo, 106 (JP); SHIRAI, Toru, Tokyo, 106-8620 (JP); YOKOSAWA, Suguru, Tokyo, 106-8620 (JP); SHOJI, Hiroki, Tokyo, 106-8620 (JP); HIRAKAWA, Yuya, Tokyo, 106-8620 (JP)
(74) Representative: Dehns Germany Partnerschaft mbB

(57) **Abstract**

Provided are a magnetic resonance imaging apparatus (10), an image processing apparatus, an image processing method, and a program that can suppress the occurrence of striped noise in an image reconstructed based on partial k-space data acquired within an asymmetrical measurement region of the k-space and generate a high-quality image. A magnetic resonance imaging apparatus (10) estimates data of a k-space by applying a half-Fourier method or a POCS method to partial measurement data (PKt) of an asymmetrical measurement region of the k-space, acquires a corrected image (F12B) in which the data of the k-space is reconstructed, acquires a smoothing-corrected image (F12C) obtained by performing smoothing filter processing on the corrected image (F12B), replaces data of the unmeasured region of the smoothing-corrected image (F12C) with zero data, and estimates the data of the unmeasured region using a first trained model.

## Description

### BACKGROUND OF THE INVENTION

### 1. Field of the Invention

The present disclosure relates to a magnetic resonance imaging apparatus, an image processing apparatus, an image processing method, and a program, and particularly relates to a signal processing technique for generating a reconstruction image from partial k-space data collected from an asymmetrical region in a k-space.

### 2. Description of the Related Art

In magnetic resonance imaging (MRI) imaging using an MRI apparatus, in order to reduce an imaging time, a half-Fourier method is used in which a k-space corresponding to a matrix size of a field of view (FOV) is partially asymmetrically measured, and data of an unmeasured region is estimated based on data of measured values acquired from a measurement region. The half-Fourier method is a method of estimating data of an unmeasured region from data of a measurement region by using Hermitian conjugate of the k-space to generate a reconstruction image. In this method, as the unmeasured region in the k-space increases, the degradation of image quality of the reconstruction image increases (see Feinberg DA, Hale JD, Watts JC, Kaufman L, Mark A. "Halving MR imaging time by conjugation: demonstration at 3.5 kG", Radiology, 1986 Nov;161(2):527-31.).

In order to solve such an issue, in US2022/0198725A, image quality of an image generated from partial measurement data is improved by using a convolutional neural network (CNN) trained through machine learning using, as training data, a pair of a reconstruction image of full measurement data collected by measuring an entire region of a matrix of the k-space and a reconstruction image of partial measurement data collected in an asymmetrical measurement region set in the k-space.

### SUMMARY OF THE INVENTION

In the method using the CNN described in US2022/0198725A, since the noise of the unmeasured region in the k-space is not estimated, the reconstruction image having a high signal-to-noise ratio (SNR) is obtained. On the other hand, due to the asymmetry of the signal intensity of the noise caused by not estimating the noise of the unmeasured region, the noise is visually recognized in a stripe shape in the reconstruction image.

The present disclosure has been made in view of such circumstances, and an object of the present disclosure is to provide a magnetic resonance imaging apparatus, an image processing apparatus, an image processing method, and a program that can suppress the occurrence of striped noise in an image reconstructed based on partial k-space data acquired within an asymmetrical measurement region of the k-space and generate a high-quality image.

A first aspect of the present disclosure relates to a magnetic resonance imaging apparatus comprising: a processor that converts data acquired by imaging a subject into an image, in which the processor acquires partial measurement data of an asymmetrical measurement region of a k-space, estimates data of an unmeasured region other than the measurement region of the k-space by applying a half-Fourier method or a projection onto convex sets (POCS) method to the partial measurement data, acquires a corrected image in which data of the k-space including the partial measurement data of the measurement region and the estimated data of the unmeasured region is reconstructed, acquires a smoothing-corrected image obtained by performing smoothing filter processing on the corrected image, acquires smoothing-corrected data of the k-space obtained by performing a Fourier transform on the smoothing-corrected image, replaces the data of the unmeasured region in the smoothing-corrected data of the k-space with zero data, acquires a smoothed image in which the data of the k-space including the smoothing-corrected data of the measurement region and the zero data of the unmeasured region is reconstructed, and estimates an output image by inputting the smoothed image to a first trained model that has been trained to receive an input of an input reconstruction image in which the data of the k-space including data of the measurement region is reconstructed and output an estimated reconstruction image in which the data of the unmeasured region is estimated.

A second aspect of the present disclosure relates to the magnetic resonance imaging apparatus according to the first aspect, in which it is preferable that the processor uses, for the smoothing filter processing, a second trained model that has been trained to receive an input of a noise image having noise and output a noise-reduced image in which the noise is reduced.

A third aspect of the present disclosure relates to the magnetic resonance imaging apparatus according to the second aspect, in which it is preferable that the second trained model has been trained using a ground-truth image having relatively less noise as ground-truth data and an image in which the noise is added to the ground-truth image as training data.

A fourth aspect of the present disclosure relates to the magnetic resonance imaging apparatus according to any one of the first to third aspects, in which it is preferable that the processor acquires the partial measurement data by performing a Fourier transform on a reconstruction image having striped noise.

A fifth aspect of the present disclosure relates to the magnetic resonance imaging apparatus according to any one of the first to fourth aspects, in which it is preferable that the first trained model is a trained model that has been trained through machine learning to receive an input of an input image in which the data of the k-space consisting of the measurement region filled with input measurement region data and the unmeasured region filled with zero data is reconstructed, and estimate and output the estimated reconstruction image of the real space reconstructed from the data of the k-space consisting of the measurement region filled with estimated measurement region data and the unmeasured region filled with estimated unmeasured region data.

A sixth aspect of the present disclosure relates to the magnetic resonance imaging apparatus according to any one of the first to fourth aspects, in which it is preferable that the first trained model is a trained model that has been trained through machine learning to receive an input of an input image in which the data of the k-space consisting of the measurement region filled with input measurement region data and the unmeasured region filled with zero data is reconstructed, and estimate and output an estimated residual image indicating a residual between the input image and the estimated reconstruction image of the real space reconstructed from the data of the k-space consisting of the measurement region filled with estimated measurement region data and the unmeasured region filled with estimated unmeasured region data.

A seventh aspect of the present disclosure relates to the magnetic resonance imaging apparatus according to any one of the first to sixth aspects, in which it is preferable that the processor acquires first measurement region data of the measurement region of the k-space obtained by performing a Fourier transform on the output image, generates an edge-enhanced image obtained by performing edge enhancement filter processing on the output image, acquires first unmeasured region data of the unmeasured region of the k-space obtained by performing a Fourier transform on the edge-enhanced image, and generates a resolution-improved image by reconstructing the data of the k-space including the first measurement region data and the first unmeasured region data.

An eighth aspect of the present disclosure relates to the magnetic resonance imaging apparatus according to the seventh aspect, in which it is preferable that the processor acquires a first adjacent region data corresponding to an adjacent region that is adjacent to the measurement region and extends a predetermined distance from the measurement region in second unmeasured region data of the unmeasured region of the k-space obtained by performing a Fourier transform on the output image, acquires second adjacent region data corresponding to the adjacent region in the first unmeasured region data, generates third adjacent region data from the first adjacent region data of which a weight is gradually decreased as a distance from the measurement region increases and the second adjacent region data of which a weight is gradually increased as the distance from the measurement region increases, and generates the resolution-improved image by reconstructing the data of the k-space including the first measurement region data, the third adjacent region data, and the first unmeasured region data other than the adjacent region.

A ninth aspect of the present disclosure relates to an image processing apparatus comprising: a processor that converts data acquired by imaging a subject into an image, in which the processor acquires partial measurement data of an asymmetrical measurement region of a k-space, estimates data of an unmeasured region other than the measurement region of the k-space by applying a half-Fourier method or a projection onto convex sets (POCS) method to the partial measurement data, acquires a corrected image in which data of the k-space including the partial measurement data of the measurement region and the estimated data of the unmeasured region is reconstructed, acquires a smoothing-corrected image obtained by performing smoothing filter processing on the corrected image, acquires smoothing-corrected data of the k-space obtained by performing a Fourier transform on the smoothing-corrected image, replaces the data of the unmeasured region in the smoothing-corrected data of the k-space with zero data, acquires a smoothed image in which the data of the k-space including the smoothing-corrected data of the measurement region and the zero data of the unmeasured region is reconstructed, and estimates an output image by inputting the smoothed image to a first trained model that has been trained to receive an input of an input reconstruction image in which the data of the k-space including data of the measurement region is reconstructed and output an estimated reconstruction image in which the data of the unmeasured region is estimated.

The image processing apparatus according to the ninth aspect may have the same specific aspect as the magnetic resonance imaging apparatus according to any one of the first to eighth aspects.

A tenth aspect of the present disclosure relates to an image processing method executed by a processor that converts data acquired by imaging a subject into an image, the image processing method comprising: acquiring partial measurement data of an asymmetrical measurement region of a k-space; estimating data of an unmeasured region other than the measurement region of the k-space by applying a half-Fourier method or a projection onto convex sets (POCS) method to the partial measurement data; acquiring a corrected image in which data of the k-space including the partial measurement data of the measurement region and the estimated data of the unmeasured region is reconstructed; acquiring a smoothing-corrected image obtained by performing smoothing filter processing on the corrected image; acquiring smoothing-corrected data of the k-space obtained by performing a Fourier transform on the smoothing-corrected image; replacing the data of the unmeasured region in the smoothing-corrected data of the k-space with zero data; acquiring a smoothed image in which the data of the k-space including the smoothing-corrected data of the measurement region and the zero data of the unmeasured region is reconstructed; and estimating an output image by inputting the smoothed image to a first trained model that has been trained to receive an input of an input reconstruction image in which the data of the k-space including data of the measurement region is reconstructed and output an estimated reconstruction image in which the data of the unmeasured region is estimated.

The image processing method according to the tenth aspect may have the same specific aspect as the magnetic resonance imaging apparatus according to any one of the first to eighth aspects.

An eleventh aspect of the present disclosure relates to a program for causing a computer to execute the image processing method according to the tenth aspect. The program according to the eleventh aspect may have the same specific aspect as the magnetic resonance imaging apparatus according to any one of the first to eighth aspects. The present disclosure also encompasses a tangible, non-transitory computer-readable storage medium on which the program according to the eleventh aspect is stored.

According to the present disclosure, it is possible to suppress the occurrence of the striped noise in the image reconstructed based on the partial measurement data, which is the partial k-space data acquired within the asymmetrical measurement region of the k-space, and generate the high-quality image.

### BRIEF DESCRIPTION OF THE DRAWINGS

FIG. 1 is a diagram illustrating a schematic configuration of an MRI apparatus according to an embodiment of the present disclosure.
FIG. 2 is a diagram illustrating examples of full measurement data of a k-space and an MR image reconstructed from the full measurement data.
FIG. 3 is a diagram illustrating examples of each point of data arranged in the k-space and a k-trajectory.
FIG. 4 is a diagram illustrating an example of a data filling method using asymmetric k-space sampling.
FIG. 5 is a conceptual diagram illustrating a method of improving the degradation of image quality of the MR image using a CNN.
FIG. 6 is a diagram illustrating an example of a network structure of the CNN applied as a trained model.
FIG. 7 is a diagram illustrating examples of an input image and an output image of the CNN.
FIG. 8 is a diagram illustrating an example of a method of generating a training image set for training the CNN.
FIG. 9 is a diagram illustrating an example of a method of estimating data of an unmeasured region using a POCS method from partial measurement data that is data collected in an asymmetrical measurement region in the k-space.
FIG. 10 is a diagram illustrating examples of k-space data in which the unmeasured region is estimated by the POCS method from the partial measurement data and k-space data in which the unmeasured region is estimated by a CNN estimation method.
FIG. 11 is an example of a test phantom image reconstructed from each k-space data illustrated in FIG. 10.
FIG. 12 is a diagram illustrating an outline of an image processing method according to a first embodiment.
FIG. 13 is a functional block diagram of a processor of a control device.
FIG. 14 is a flowchart illustrating steps of a striped noise reduction method according to the first embodiment.
FIG. 15 is a diagram illustrating the degradation in resolution of the MR image by the CNN estimation method.
FIG. 16 is a diagram illustrating an outline of an image processing method according to a second embodiment.
FIG. 17 is a functional block diagram of a processor according to the second embodiment.
FIG. 18 is a flowchart illustrating steps of a generation method of an MR image according to the second embodiment.
FIG. 19 is a diagram illustrating the improvement in resolution.
FIG. 20 is a diagram illustrating a generation method of an MR image according to a third embodiment.
FIG. 21 is a graph illustrating a Hanning window function.
FIG. 22 is a flowchart illustrating steps of a generation method of an MR image according to the third embodiment.

### DESCRIPTION OF THE PREFERRED EMBODIMENTS

Hereinafter, preferred embodiments of the present invention will be described in detail with reference to the accompanying drawings. In this specification, the same components are denoted by the same reference numerals, and duplicate description thereof will be omitted as appropriate.

### Configuration of Magnetic Resonance Imaging Apparatus

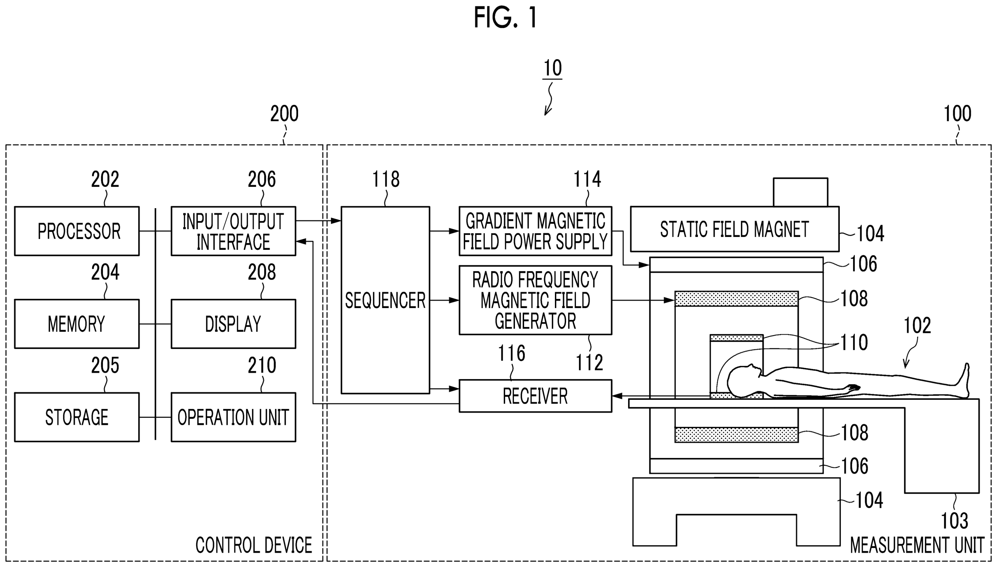

FIG. 1 is a diagram illustrating a schematic configuration of an MRI apparatus 10 according to the embodiment of the present disclosure. The MRI apparatus 10 comprises a measurement unit 100 and a control device 200. The measurement unit 100 comprises a static field magnet 104, a gradient coil 106, a radio frequency (RF) coil 108, a radio frequency magnetic field generator 112, a gradient magnetic field power supply 114, a receive coil 110, a receiver 116, and a sequencer 118.

The measurement unit 100 includes a gantry having a cylindrical imaging space called a bore, and elements such as the static field magnet 104, the gradient coil 106, and the RF coil 108 are disposed in the gantry. A subject 102 is usually placed in the imaging space in the gantry in a state of lying on a bed 103. The bed 103 may be fixed to the gantry or may be a movable dockable bed that is attachable to and detachable from the gantry.

The static field magnet 104 generates a uniform static magnetic field in the imaging space in which the subject 102 is placed. The static field magnet 104 includes a static magnetic field generation source of a permanent magnet type, a normal conduction type, or a superconducting type. The gradient coil 106 generates a gradient magnetic field in the imaging space. The RF coil 108 generates a radio frequency magnetic field that generates a nuclear magnetic resonance (NMR) signal in atomic nuclei of atoms constituting a tissue of the subject 102. The RF coil 108 is also referred to as a transmit coil. The receive coil 110 detects the NMR signal generated from the subject 102. The receive coil 110 is also referred to as an RF probe.

The sequencer 118 transmits control information to the radio frequency magnetic field generator 112 and the gradient magnetic field power supply 114 according to a pulse sequence (imaging sequence). The radio frequency magnetic field generator 112 generates radio frequency current pulses at the Larmor frequency that cause nuclear magnetic resonance based on the control information input from the sequencer 118, and transmits the radio frequency current pulse to the RF coil 108. The RF pulses corresponding to the radio frequency current pulses are transmitted from the RF coil 108 to the subject 102.

The receive coil 110 detects the NMR signal generated by exciting the nuclear spins in the subject 102 by the RF pulses, and transmits the detected NMR signal. The NMR signal is usually collected as a gradient echo or a spin echo, and is referred to herein as an echo signal. The receive coil 110 illustrated in FIG. 1 is a coil that receives the echo signal from the head of the subject 102, but is not limited to the receive coil that receives the echo signal from the head, and a receive coil corresponding to an examination part of the subject 102 such as the chest, the abdomen, the waist, the shoulder, and the hand and foot may be used and appropriately set. Further, there is also a flexible blanket type receive coil that is placed over the chest, the abdomen, and the waist.

The gradient coil 106 is composed of an X-axis gradient coil, a Y-axis gradient coil, and a Z-axis gradient coil that generate gradient magnetic fields Gx, Gy, and Gz in the X-axis direction, the Y-axis direction, and the Z-axis direction of the imaging space, respectively, and generates the gradient magnetic field corresponding to the current supplied from the gradient magnetic field power supply 114 in the imaging space. In the imaging space, an orthogonal tri-axial coordinate system is usually defined such that a direction of a central axis of the gantry is a Z-axis direction, a vertical direction is a Y-axis direction, and a direction orthogonal to both the Z-axis and the Y-axis is an X-axis direction.

The Z-axis gradient coil generates the gradient magnetic field Gz for selecting a slice position and a slice width of a plane of the subject 102 orthogonal to the Z-axis direction. The X-axis gradient coil generates the gradient magnetic field Gx proportional to the position in the X-axis direction as a readout direction (frequency encoding direction) gradient magnetic field during a period in which the echo signal is generated. The Y-axis gradient coil generates the phase encoding direction gradient magnetic field Gy having different intensities for each repetition time (TR).

The sequencer 118 controls each unit to operate at timing and intensity that are programmed in advance. Among the programs, in particular, a program describing the timing or the intensity of the RF pulse, the gradient magnetic fields Gx, Gy, and Gz, and the signal reception is called a pulse sequence.

Various pulse sequences are known depending on the purpose, and for example, a spin echo method and a gradient echo method are known, and various pulse sequences derived from these methods are known. In addition, there is echo planar imaging (EPI), which is one of the high-speed imaging methods. In EPI, there are single-shot EPI, in which, during excitation by a single RF pulse, the gradient magnetic field is repeatedly reversed to generate a plurality of gradient echoes and fill k-space (the spatial-frequency domain) with the data required for image reconstruction, and multi-shot EPI, in which k-space is filled with echo-train data obtained over a plurality of shots.

The NMR signal generated from the subject 102 is detected by the receive coil 110, amplified by a preamplifier (not illustrated) in the receive coil 110, and transmitted to the receiver 116.

The receiver 116 includes a quadrature detection circuit, an analog-to-digital (A/D) converter, and other signal processing circuits. In the receiver 116, the amplified NMR signal is subjected to the A/D conversion and required signal processing to generate data. The data generated in this manner is transmitted to the control device 200.

For example, the receiver 116 executes the detection and the A/D conversion of the echo signal detected by the receive coil 110, and transmits two streams of digital data of a real part and an imaginary part to the control device 200. The digital data is also referred to as reception signal data or measurement data.

The sequencer 118 transmits information on the nuclear magnetic resonance frequency (detection reference frequency) that is a reference for quadrature detection performed by the receiver 116, a timing of the A/D conversion (sampling timing in the frequency encoding direction), and the like, and controls the receiver 116.

A reception-side cable (not illustrated) that outputs the NMR signal received by the receive coil 110 is connected to the receive coil 110. Although not illustrated in FIG. 1, a reception-side connector is connected to an end part of the reception-side cable. The reception-side connector is connected to a bed-side connector provided at the bed 103. The bed-side connector is connected to a bed-side cable disposed inside the bed 103, and the bed-side cable is connected to the control device 200.

As a result, the receive coil 110 is communicably connected to the control device 200 and the sequencer 118. The connection between the receive coil 110 and the control device 200 and the sequencer 118 is not limited to a wired connection such as a cable, and an aspect in which the connection is made wirelessly is also possible. In this case, the receive coil 110 or the bed 103 further includes at least an A/D conversion module and a wireless communication module.

The control device 200 is an example of an image processing apparatus that causes a processor to convert data acquired by imaging a subject into an image. The control device 200 controls the measurement unit 100 and performs various calculations such as image reconstruction based on the signal obtained from the measurement unit 100. The control device 200 can be configured by using a computer. The computer applied to the control device 200 may be a personal computer, a workstation, or a server computer.

The control device 200 comprises a processor 202, a memory 204, a storage 205, an input/output interface 206, a display 208, an operation unit 210, and the like as hardware.

The processor 202 includes a central processing unit (CPU). The processor 202 may include a graphics processing unit (GPU). In addition, the processor 202 may include one or a plurality of hardware components of a digital signal processor (DSP), an application-specific integrated circuit (ASIC), a programmable logic device (PLD), and the like.

The processor 202 performs overall control of each unit of the control device 200 and the measurement unit 100, and executes various programs stored in the memory 204 to execute various functions.

The memory 204 is a storage device including a random-access memory (RAM). The memory 204 may include one or more of a flash memory and a read-only memory (ROM). The storage 205 is a storage device including, for example, one or more of a hard disk device, a solid state drive device, and a removable recording medium. The flash memory, the ROM, and the storage 205 are non-volatile storage devices that store an operation system, a program for causing the processor 202 to function as the control device 200, various pulse sequences, a calculation formula used for image reconstruction, parameters, a trained model, an MR image reconstructed by image reconstruction, and the like.

The RAM functions as a work area for processing by the processor 202, and temporarily stores the programs and the like stored in the non-volatile storage device. In addition, the RAM functions as a place for temporarily storing the measurement data that is digital sampling data obtained by processing the echo signal obtained from the measurement unit 100, that is, so-called raw data. A portion (RAM) of the memory 204 may be provided in the processor 202.

The input/output interface 206 includes a communication unit that is connectable to a network, a connection unit that is connectable to an external device, and the like. As the connection unit that is connectable to the external device, a universal serial bus (USB) (USB is a registered trademark), a high-definition multimedia interface (HDMI) (HDMI is a registered trademark), and the like can be applied.

The processor 202 communicates with the device (in the present example, the sequencer 118) and the receiver 116 disposed in the measurement unit 100 via the input/output interface 206 to transmit and receive required information. In addition, a portion of the sequencer 118 may be provided on the control device 200 side.

The display 208 is configured by, for example, a liquid crystal display, an organic electroluminescence (OEL) display, a projector, or an appropriate combination thereof. Various types of information are displayed on the display 208, in addition to the MR image captured by the MRI apparatus 10. The display 208 is used as a portion of a user interface (UI) in a case of receiving an input from the operation unit 210. The display 208 is not limited to a single display device, and can also be in a multi-display form comprising a plurality of display devices.

The operation unit 210 includes an input device such as a mouse and a keyboard, and functions as a part of a graphical user interface (GUI) that receives an input from an operator using a display operation window of the display 208. For example, the operation unit 210 and the display 208 function as a GUI for the operator to activate and stop (pause) the measurement unit 100, select the pulse sequence, and input the imaging conditions, the processing conditions, or the like. The operation unit 210 may include an audio input device. Further, the operation unit 210 may be a touch panel type input device that is integrally configured with a display screen of the display 208.

### Relationship between Data of k-Space and Image Data of Real Space

The k-space is a space representing a wave number (spatial frequency) distribution of image data of a real space, and the image data of the real space and the data of the k-space have a relationship in which the image data and the data of the k-space can be converted to each other by a Fourier transform and an inverse Fourier transform. Since the NMR signal is expressed as a Fourier transform of the nuclear magnetization distribution, the NMR signal can be regarded as a signal in wavenumber space (k-space) by converting the variables of resonance frequency and time into position coordinates and wavenumber based on the Larmor equation and a linear gradient magnetic field. That is, the k-space in MRI is understood as a data space that stores the measurement data obtained by digitally sampling the echo signal, and is also referred to as a measurement space. The measurement data is understood as k-space data that is mapped into the k-space.

In general, the k-space, which is a Fourier transform space of the real space, is defined as a three-dimensional k-space by a coordinate system of wave numbers (kx, ky, kz) corresponding to a coordinate system of positions (x, y, z) in the real space, but, here, as a typical example of the MRI, a case will be described in which a two-dimensional image is generated from two-dimensional k-space data by performing frequency encoding and phase encoding in an imaging tomographic plane designated by slice selection using the gradient magnetic field in the Z direction.

The two-dimensional k-space is represented by, for example, a two-dimensional plane in which a kx axis as the horizontal axis is a frequency encoding axis and a ky axis as the vertical axis is a phase encoding axis. The definition of each axis (dimension) is not limited to the above example.

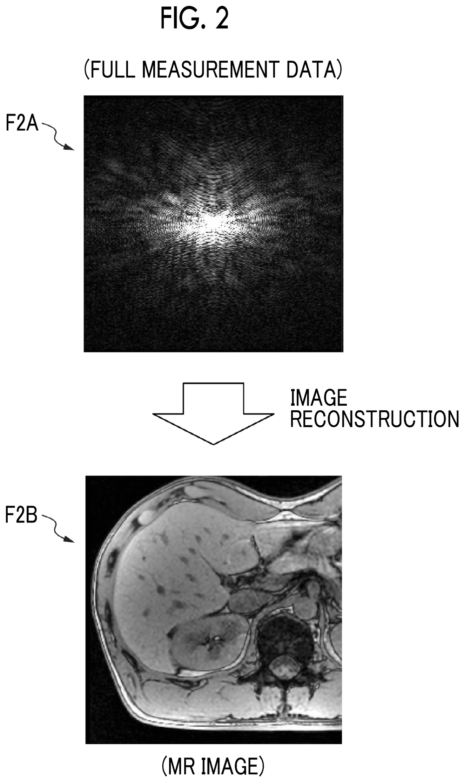

FIG. 2 is a diagram illustrating examples of full measurement data of the k-space and the MR image reconstructed from the full measurement data. The "full measurement data" refers to complete k-space data that is data collected in an entire region of a matrix (data acquisition matrix) of the k-space set by the imaging parameters as a measurement region. The matrix of the k-space is defined by the FOV, the number of pixels in the frequency encoding direction, and the number of pixels in the phase encoding direction.

For example, in a case in which the matrix size of the FOV is set to 256 × 256, the data in the k-space is data (also referred to as "raw data") sampled at equal intervals (data pitch Δk) at 256 points × 256 points of the k-space. In addition, the upper and lower limits of the acquisition of the data in the k-space are determined in accordance with the spatial resolution of the MR image.

The data near the origin of the k-space (portion in which the values of kx and ky are small) has a low spatial frequency, and a component representing a rough structure of the image is present, and the data in a peripheral portion of the k-space (portion in which the value of kx or ky is large) has a high spatial frequency, and a component representing a fine structure of the image is present.

Full measurement data F2A is complex data, and includes real part k-space data and imaginary part k-space data. The full measurement data F2A illustrated in the upper part of FIG. 2 is displayed as a complex amplitude image. An image F2B reconstructed by performing an inverse Fourier transform on the full measurement data F2A is a complex image. The image F2B illustrated in the lower part of FIG. 2 is displayed as an absolute value image obtained by performing absolute value image generation on the complex image.

### Collection of Data of k-Space

The MRI apparatus 10 controls the sampling timing of the RF pulse, the gradient magnetic fields Gx, Gy, and Gz, and the echo signal generated from the RF coil 108 in accordance with the pulse sequence selected depending on the examination part and the imaging purpose, and collects the data that fills the k-space.

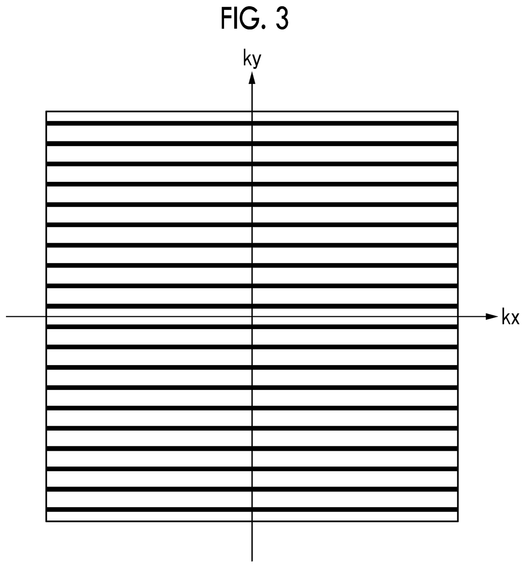

FIG. 3 is a diagram illustrating examples of each point (kx, ky) of the data arranged in the k-space and the k-trajectory. Here, as an example, a case will be described in which the kx axis is the frequency encoding axis and the ky axis is the phase encoding axis. For example, in a case of the pulse sequence of the spin echo method, the gradient magnetic field Gx is generated in synchronization with the period during which the echo signal is generated, and the echo signal is sampled during the period to collect data for one line in the kx direction of the k-space. The collection of the data for one line is performed for each repetition time TR. That is, the data in the kx direction of the k-space is collected by one echo. The kx direction is also referred to as a "readout direction". The data in the ky direction is collected by varying the intensity of the gradient magnetic field Gy for each TR in the collection of the data in the kx direction. For example, the full measurement data in a case in which the matrix size of the k-space is 256 × 256 is data of 256 points of sampling in the frequency encoding direction × the number of steps 256 in the phase encoding direction. Therefore, it takes a time of "TR × the number of steps of phase encoding" to collect the full measurement data for filling the entire region of the k-space having the designated matrix size. In the pulse sequence of the spin echo method or the like, it takes several minutes to collect the full measurement data that fills the k-space as the imaging time.

### Example of Reduction in Imaging Time by Partial Sampling of k-Space

In the related art, a half-Fourier method is known as a method of reducing the imaging time. In the half-Fourier method, data of an asymmetrical region that is a partial region in the k-space is collected instead of collecting the full measurement data. For example, a method called half-scan that reduces the number of steps in the phase encoding direction and a method called half-echo that reduces the number of sampling points in the frequency encoding direction are known.

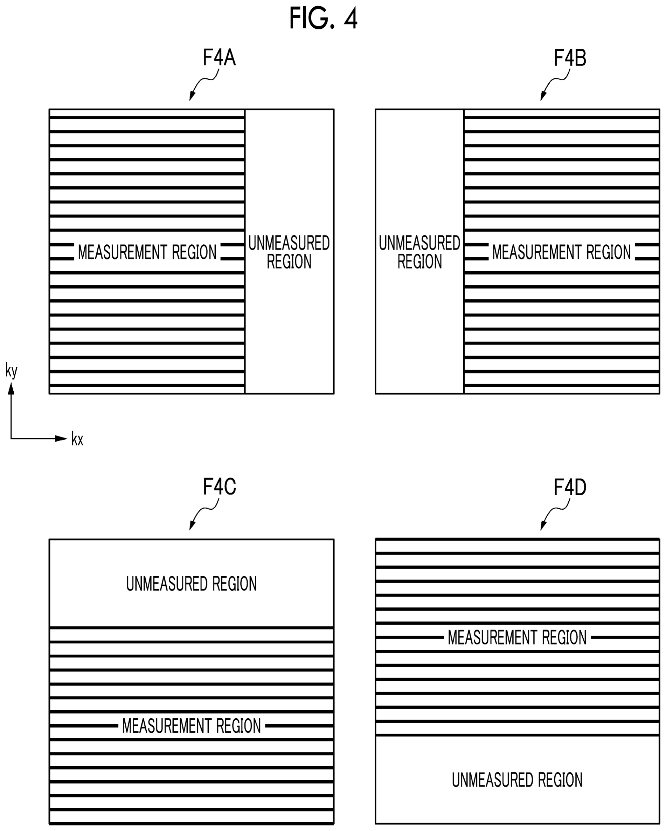

FIG. 4 is a diagram illustrating an example of a data filling method using the asymmetric k-space sampling. As a pattern in which the unmeasured region is set in one of four directions, that is, up, down, left, and right, on the two-dimensional plane of the k-space, there are four possible patterns as illustrated in FIG. 4.

In a k-space F4A illustrated in the upper left of FIG. 4, the unmeasured region is present in the right direction (positive kx direction) of the k-space, and the data is collected in a region other than the unmeasured region as the measurement region. As a result, partial k-space data in which the measurement data fills the asymmetrical measurement region in the k-space F4A is obtained.

In a k-space F4B illustrated in the upper right of FIG. 4, the unmeasured region is present in the left direction (negative kx direction) of the k-space. In addition, in a k-space F4C illustrated in the lower left of FIG. 4, the unmeasured region is present in the up direction (positive ky direction) of the k-space, and in a k-space F4D illustrated in the lower right of FIG. 4, the unmeasured region is present in the down direction (negative ky direction) of the k-space.

As in the k-spaces F4A and F4B illustrated in the upper part of FIG. 4, in a case in which the k-space is filled with the measurement data collected by the half-echo method in which the number of sampling points in the frequency encoding direction is small, the collection time of the data for one line in the frequency encoding direction can be reduced, and particularly in a case in which the pulse sequence is EPI, the data of the k-space required for reconstructing one MR image can be collected in a shorter time.

In addition, as in the k-spaces F4C and F4D illustrated in the lower part of FIG. 4, in a case in which the k-space is filled with the measurement data collected by the half-scan measurement method in which the number of steps in the phase encoding direction is small, the number of phase encodings is reduced, and the imaging time can be reduced regardless of the type of the pulse sequence.

In FIG. 4, the example has been described in which the unmeasured region is set in any one direction among the four directions of up, down, left, and right of the k-space, but the k-space to which the half-Fourier method can be applied is not limited to the four patterns of the k-space illustrated in FIG. 4, and a k-space in which both the half-scan and the half-echo are used and two adjacent regions among the asymmetrical regions in the four directions of up, down, left, and right of the k-space are set as the unmeasured regions may be used. From the symmetry (Hermitian symmetry) of the k-space information, the measurement region of the k-space may be a region exceeding one quadrant of the first quadrant to the fourth quadrant in which the two-dimensional plane of the k-space is divided into four quadrants with the origin of the kx axis and the ky axis as the center.

The processor 202 functions as a measurement controller that transmits the pulse sequence, the imaging conditions (imaging parameters) designated by the operator, and the like to the sequencer 118, and controls the measurement unit 100 via the sequencer 118. In the embodiment of the present disclosure, the sequence for performing the half-scan measurement of reducing the number of steps in the phase encoding direction and/or the half-echo measurement of reducing the number of sampling points in the frequency encoding direction may be selected. The proportion of the unmeasured region of the k-space in a case of performing the half-scan measurement and/or the half-echo measurement is set to any of 1% to 45% by the operator, and the direction of the unmeasured region is also set by the operator. The setting of the proportion and the direction of the unmeasured region may be achieved by setting the proportion and the direction of the measurement region other than the unmeasured region. The user interface may receive the setting of the proportion and the direction of the measurement region or may receive the setting of the proportion and the direction of the unmeasured region.

The processor 202 transmits an instruction to the sequencer 118 in accordance with the condition set by the imaging parameters, and causes the measurement unit 100 to execute the pulse sequence under the control of the sequencer 118. The subject 102 is imaged by executing the pulse sequence by the measurement unit 100, and the receive coil 110 provided at the examination part of the subject 102 receives the echo signal from the subject 102. The receiver 116 executes the amplification, the detection, and the A/D conversion of the echo signal received by the receive coil 110, and transmits the digital data of the real part and the imaginary part to the control device 200 via the input/output interface 206. In this manner, the measurement data is acquired. In this specification, the measurement data of the k-space including the unmeasured region is referred to as "partial measurement data". The term "partial measurement data" is not limited to the data acquired by the asymmetric sampling, and is also used for partial measurement data generated by discarding a part of the full-sampled full measurement data.

### Method of Improving MR Image: CNN Estimation Method

The half-Fourier method has a disadvantage that the image quality of the reconstruction image is significantly degraded (deteriorates) as the unmeasured region becomes large. On the other hand, there is also a method of, for the k-space including the asymmetrical unmeasured region illustrated in FIG. 4, generating the reconstructed image by performing an inverse Fourier transform on the k-space data complemented by filling the unmeasured region with zero data without applying Hermitian-symmetry-based complement. However, the reconstruction image reconstructed by such a simple zero-filling complement has degraded image quality due to zero data filling the unmeasured region.

As one of the techniques for estimating the asymmetrical unmeasured region in the k-space for improving the image quality of the reconstruction image based on the partial k-space data obtained from the sampling region set asymmetrically on the k-space, US2022/0198725A proposes a method of improving the image quality of the MR image by using a trained neural network model trained through machine learning. The neural network model is, for example, a multi-layer convolutional neural network (CNN) model.

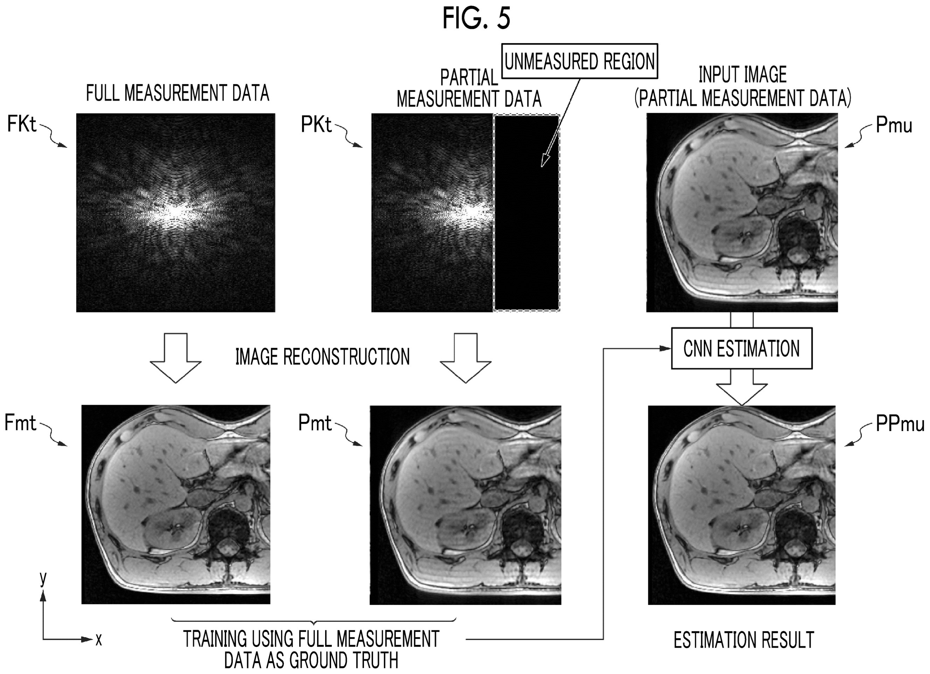

FIG. 5 is a conceptual diagram illustrating the method of improving the degradation of image quality of the MR image using the CNN. In this specification, a method of estimating the data of the unmeasured region using the trained CNN to improve the image quality of the reconstruction image is referred to as a "CNN estimation method".

In the CNN estimation method, first, as a preliminary preparation, the trained CNN is generated by machine learning. In this training phase, machine learning is performed using, as the training data, a pair of a full measurement image Fmt that is the reconstruction image reconstructed from full measurement data Fkt and a partial measurement image Pmt that is the reconstruction image reconstructed from partial measurement data PKt corresponding to the full measurement image Fmt, and the full measurement image Fmt being ground-truth data, so that the trained CNN trained to estimate the full measurement image Fmt from the partial measurement image Pmt is generated. The subscript "t" in the symbols such as Fkt and PKt is an index representing a "pair" of data in the training dataset.

The partial measurement data PKt can be generated by replacing the data of a partial region of the full measurement data Fkt with zero data. That is, by regarding the partial region of the k-space matrix of the full measurement data Fkt as the unmeasured region and replacing the data of the partial region with zero data, the partial measurement data PKt equivalent to the measurement data obtained by the asymmetric sampling can be generated. A direction in which the region regarded as the unmeasured region in the k-space is set and a proportion of the unmeasured region with respect to the entire region of the matrix size of the k-space can be arbitrarily set, and the partial measurement data obtained by the asymmetric sampling under various conditions can be pseudo-generated.

The number of image pairs in the training dataset used for the machine learning of the CNN is preferably about 40,000. In the training dataset in a case in which one CNN is trained through machine learning, it is desirable that the directions of the unmeasured region of the partial measurement data PKt corresponding to the partial measurement image Pmt in the k-space are the same direction, and the proportions of the unmeasured region in the k-space are also the same. In this specification, the direction of the unmeasured region in the k-space is referred to as an "unmeasured direction", and the proportion of the unmeasured region with respect to the entire region of the matrix size of the k-space is referred to as an "unmeasured proportion". The unmeasured proportion can be represented in percentage, and is synonymous with an unmeasured percentage.

For example, since the unmeasured direction of the partial measurement data PKt illustrated in FIG. 5 is the right in FIG. 5, the unmeasured direction of the k-space data corresponding to each of a plurality of partial measurement images Pmt included in the training dataset is the right direction. In addition, in a case in which the unmeasured proportion of the partial measurement data PKt is 40%, the unmeasured proportion of the k-space corresponding to each of the plurality of partial measurement images Pmt included in the training dataset is also 40%.

As a result, it is possible to obtain the trained CNN having high estimation accuracy for the input of the partial measurement image in which the unmeasured direction is the right direction and the unmeasured proportion is 40%.

Similarly, a plurality of types of trained CNNs can be generated by using the training dataset in which the conditions of the unmeasured direction and the unmeasured proportion are different.

The right column of FIG. 5 represents an inference phase in which the full measurement image is estimated based on a partial measurement image Pmu using the trained CNN.

The partial measurement image Pmu that is the input image to the trained CNN is a reconstruction image reconstructed by performing an inverse Fourier transform on zero-filling partial measurement data complemented by filling the unmeasured region of the partial measurement data collected from the asymmetrical measurement region in the k-space with zero data. The image quality of this input image is degraded as compared with the reconstruction image reconstructed from the full measurement data.

The "inverse Fourier transform" in the processing of the computer is an "inverse discrete Fourier transform", and an inverse fast Fourier transform (IFFT) is applied in the embodiment of the present disclosure. Similarly, the "Fourier transform" in the processing of the computer is a "discrete Fourier transform", and a fast Fourier transform (FFT) is applied in the embodiment of the present disclosure.

The trained CNN to which the partial measurement image Pmu is input estimates the full measurement image from the partial measurement image Pmu and outputs an estimation image PPmu as the estimation result. The estimation image PPmu is an image in which the degradation of image quality of the input image is reduced (improved). In a case in which the function of the trained CNN is reconsidered as an action on the data of the k-space, it is understood that the trained CNN has a function of estimating the data of the unmeasured region.

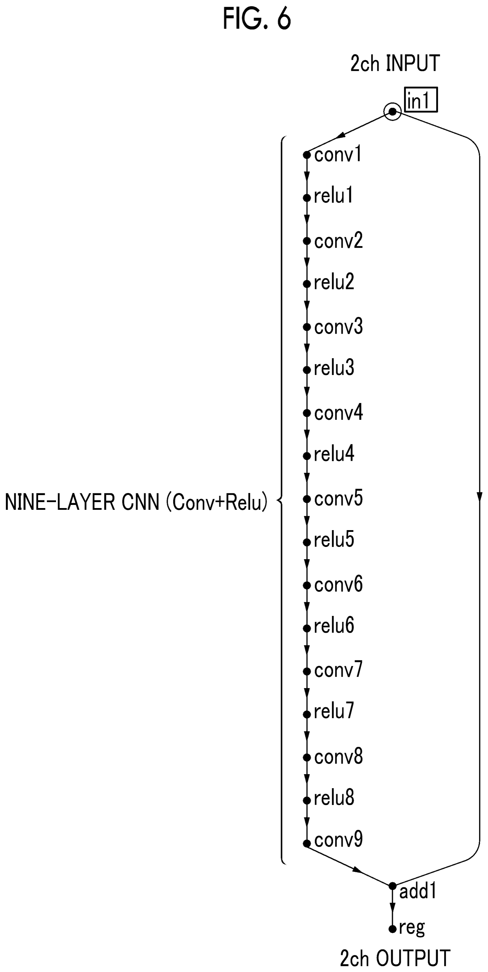

FIG. 6 is a diagram illustrating an example of a network structure of the CNN applied as the trained model. The CNN illustrated in FIG. 6 is a neural network that receives the input of the complex image and outputs the complex image, and is a multi-layer neural network model having two-channel input and two-channel output, in which each of an input channel and an output channel includes a real part and an imaginary part.

The CNN illustrated in FIG. 6 has a network structure of residual learning in which input data is output by being added to the output of a multi-layer CNN in which a plurality of stages of convolutional layers (Conv) and activation layers (Relu) are sequentially connected. Here, the notation "Relu" represents a rectified linear unit applied to the activation layer.

In the neural network model of FIG. 6, the degradation of image quality of the complex image is estimated for the two-channel complex image input to an input layer (in1) through nine convolutional layers (Conv1 to 9) and eight activation layers (Relu1 to 8), and the two-channel correction information for correcting the degradation of image quality is output to an addition layer (add1). The input layer (in1) is connected to another input of the addition layer (add1), and the two-channel complex image input to the input layer (in1) is added thereto. The addition layer (add1) adds the two-channel complex image input to the input layer (in1) and the two-channel correction information output from the convolutional layer (Conv9), and outputs the two-channel image (complex image) as an addition result as the output image via a reg layer. The reg layer may be understood as an output layer that outputs an addition result of the addition layer (add1).

In FIG. 6, the neural network model of the residual learning including the nine-layer CNN is illustrated, but the number of convolutional layers, the number of rectified linear units, and the structure of the network are not particularly limited, and are not limited to the embodiment illustrated in FIG. 6. For example, the network structure may not have the addition layer or may have a pooling layer, and a network such as a U-Net may be used. The CNN applied to the MRI apparatus 10 can have various layer structures. Further, the trained model applied to the MRI apparatus 10 is not limited to the CNN, and may be another machine learning model, and any model may be used as long as the model is trained using a machine learning dataset. The "neural network", the "trained model", and the like are, in substance, programs.

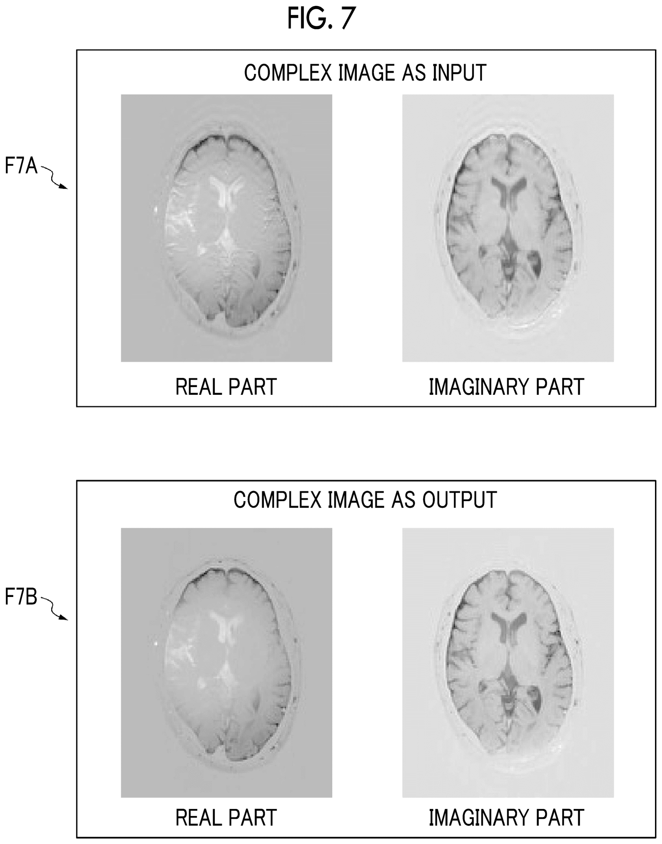

FIG. 7 is a diagram illustrating an example of the input image and the output image of the CNN illustrated in FIG. 6. As illustrated in the upper part of FIG. 7, a two-channel complex image F7A of a real part image and an imaginary part image is input to the input layer (in1) of the CNN illustrated in FIG. 6.

The measurement data measured by the MRI apparatus is complex data, and the real part data and the imaginary part data are arranged in the real part k-space and the imaginary part k-space, respectively. The complex image F7A illustrated in FIG. 7 is a real part image obtained by performing an inverse Fourier transform on the data of the real part k-space and an imaginary part image obtained by performing an inverse Fourier transform on the data of the imaginary part k-space. The complex image F7A is an example of an image reconstructed from k-space data obtained by zero-filling complement of the partial measurement data with the unmeasured proportion of 40%.

The CNN illustrated in FIG. 6 receives the input of the complex image F7A and outputs a complex image F7B illustrated in the lower part of FIG. 7.

### Method of Generating Training Image Set

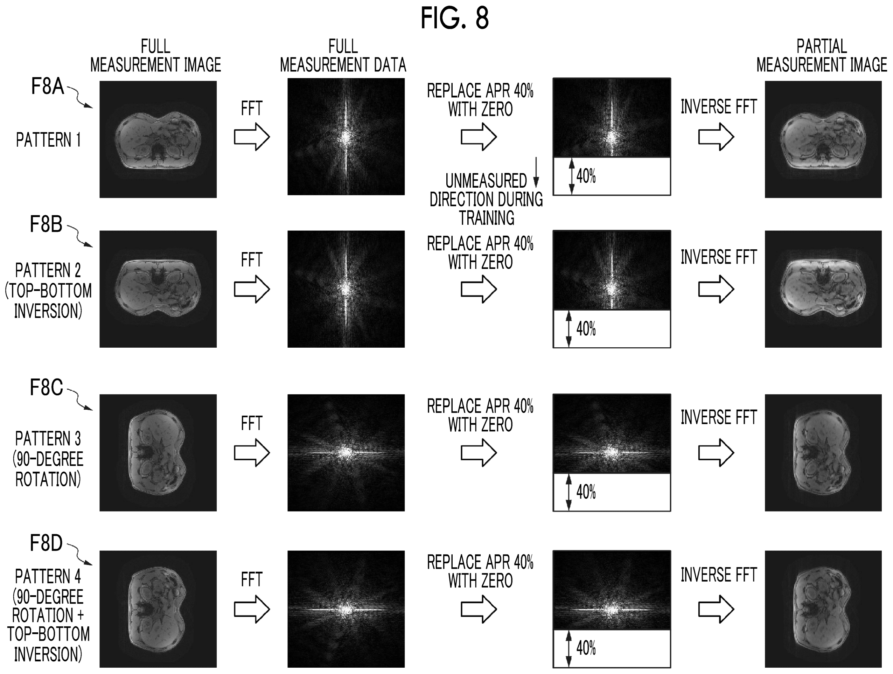

FIG. 8 is a diagram illustrating an example of a method of generating the training image set for training the CNN. The partial measurement image used for the machine learning can be created from the full measurement image. Each of the full measurement image and the partial measurement image is a complex image, but in FIG. 8, for convenience of illustration, an absolute value image is displayed.

FIG. 8 illustrates an outline of a method of generating the training image sets corresponding to four patterns 1 to 4 in which the unmeasured directions are different from one full measurement image.

An image generation process F8A illustrated in the first row, which is the uppermost part of FIG. 8, is a method of generating the partial measurement image corresponding to the reconstruction image of the partial measurement data in a case (pattern 1) in which the unmeasured direction is present in the negative direction of the ky axis in the k-space (kx, ky).

The full measurement image illustrated in the leftmost part of the first row is the full measurement image reconstructed from the full measurement data in the k-space, and is used as the ground-truth data as it is.

Meanwhile, the partial measurement image that is the training image paired with the ground-truth data is generated as follows.

The unmeasured region that is asymmetrically set in advance is filled with zero data for the full measurement data in the k-space obtained by performing a fast Fourier transform on the full measurement image. That is, the measurement data corresponding to the preset unmeasured region of the full measurement data in the k-space is replaced with the zero data. In a case of the pattern 1, the unmeasured direction is the down direction on FIG. 8, and the unmeasured proportion is 40%. The partial measurement image reconstructed by performing an inverse fast Fourier transform on the partial k-space data generated in this way is used as the training image.

An image generation process F8B illustrated in the second row of FIG. 8 is a method of generating the partial measurement image corresponding to the reconstruction image of the partial measurement data in a case (pattern 2) in which the unmeasured direction is present in the positive direction of the ky axis in the k-space (kx, ky).

The full measurement image illustrated in the leftmost part of the second row is a top-bottom inverted image in which the top and bottom of the full measurement image illustrated in the first row are inverted, and this top-bottom inverted image is used as the ground-truth data.

Then, the measurement data of the unmeasured region that is asymmetrically set in advance is replaced with zero data for the full measurement data in the k-space obtained by performing a fast Fourier transform on the top-bottom inverted image. In a case of the pattern 2, the unmeasured direction of the top-bottom inverted k-space is the down direction on FIG. 8, and the unmeasured proportion is 40%. The partial measurement image reconstructed by performing an inverse fast Fourier transform on the partial k-space data generated in this way is used as the training image.

An image generation process F8C illustrated in the third row of FIG. 8 is a method of generating the partial measurement image corresponding to the reconstruction image of the partial measurement data in a case (pattern 3) in which the unmeasured direction is present in the positive direction of the kx axis in the k-space (kx, ky).

The full measurement image illustrated in the leftmost part of the third row is a 90-degree rotated image in which the full measurement image illustrated in the first row is rotated by 90 degrees clockwise, and this 90-degree rotated image is used as the ground-truth data.

Then, the measurement data of the unmeasured region that is asymmetrically set in advance is replaced with zero data for the full measurement data in the k-space obtained by performing a fast Fourier transform on the 90-degree rotated image. In a case of the pattern 3, the unmeasured direction of the k-space rotated by 90 degrees is the down direction on FIG. 8, and the unmeasured proportion is 40%. The partial measurement image reconstructed by performing an inverse fast Fourier transform on the partial k-space data generated in this way is used as the training image.

An image generation process F8D illustrated in the fourth row, which is the lowermost part of FIG. 8, is a method of generating the partial measurement image corresponding to the reconstruction image of the partial measurement data in a case (pattern 4) in which the unmeasured direction is present in the negative direction of the kx axis in the k-space (kx, ky).

The full measurement image illustrated in the leftmost part of the fourth row is an image obtained by further inverting the top and bottom of the 90-degree rotated image illustrated in the third row (an image in which the full measurement image of the first row is rotated by 90 degrees and then top-bottom inverted), and this image is used as the ground-truth data.

Then, the measurement data of the unmeasured region that is asymmetrically set in advance is replaced with zero data for the full measurement data in the k-space obtained by performing a fast Fourier transform on the full measurement image illustrated in the fourth row. In a case of the pattern 4, the unmeasured direction of the k-space rotated by 90 degrees and top-bottom inverted is the down direction on FIG. 8, and the unmeasured proportion is 40%. The partial measurement image reconstructed by performing an inverse fast Fourier transform on the partial k-space data generated in this way is used as the training image.

With the method of generating the training image set, the training image sets corresponding to the patterns 1 to 4 can be efficiently generated from one full measurement image.

In addition, the training image sets illustrated in the patterns 1 to 4 have the proportion of the unmeasured region of 40% with respect to the entire region of the k-space, but the training image set can be generated in the same manner for a proportion other than the proportion of the unmeasured region of 40%.

Further, in the example illustrated in FIG. 8, the full measurement data of the k-space corresponding to the full measurement image is acquired by performing a Fourier transform on the full measurement image corresponding to the patterns 1 to 4, but in a case in which the full measurement data in the k-space acquired during the imaging is stored, the stored full measurement data may be top-bottom inverted and/or rotated by 90 degrees to acquire the full measurement data in the k-space corresponding to the patterns 1 to 4.

### Outline of POCS Method

As another technique for estimating the data of the unmeasured region from the partial measurement data collected by the asymmetric sampling of the k-space, the projection onto convex sets (POCS) method is known. The POCS method is described in, for example, E.M Haacke, E.D Lindskog, W Lin,"A fast, iterative, partial-fourier technique capable of local phase recovery", Journal of Magnetic Resonance, Volume 92, Issue 1, 1991 and Partial k-space Reconstruction, the internet <URL: https://users.fmrib.ox.ac.uk/~karla/reading_group/lecture_notes/Recon_Pauly_read.pdf>.

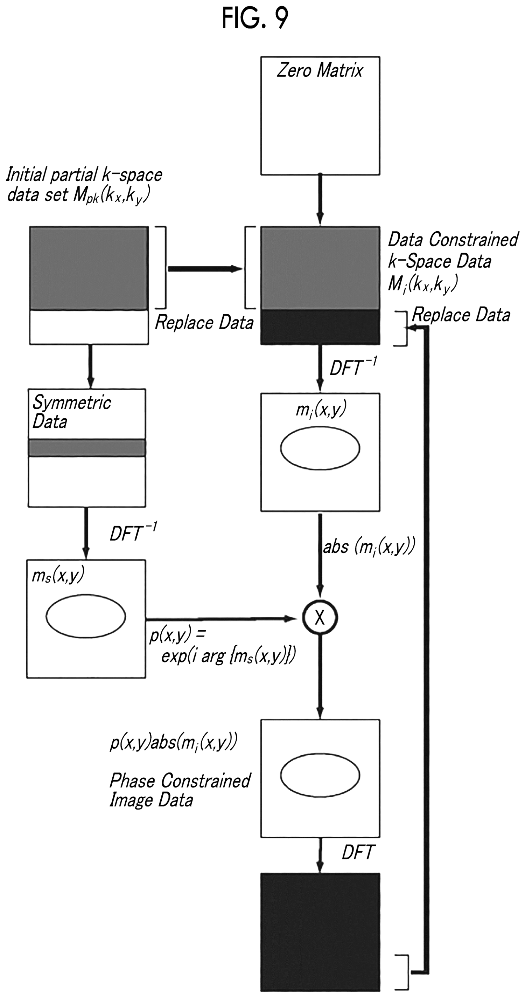

FIG. 9 is a diagram illustrating an example of a method of estimating data of the unmeasured region using the POCS method from the partial measurement data that is data collected in the asymmetrical measurement region in the k-space. FIG. 9 is cited from the description of "Figure 2.17: POCS algorithm" of Partial k-space Reconstruction, the internet <URL: https://users.fmrib.ox.ac.uk/~karla/reading_group/lecture_notes/Recon_Pauly_read.pdf>.

In the algorithm of the POCS method illustrated in FIG. 9, a low-resolution image ms(x, y) is generated by performing an inverse discrete Fourier transform based on data of a symmetric region of a central portion of partial k-space data Mpk(kx, ky) acquired by the asymmetric sampling of the k-space, and a phase image p(x, y) is generated from the image ms(x, y).

Meanwhile, an image mi(x, y) is generated by performing an inverse discrete Fourier transform based on k-space data Mi(kx, ky) obtained by combining the partial k-space data Mpk(kx, ky) and replacement data for complementing the unmeasured region of the partial k-space data Mpk(kx, ky), and an absolute value image abs(mi(x, y)) is generated from the image mi(x, y). In addition, initial replacement data in the unmeasured region may be zero data.

Then, phase correction is performed by applying the phase image p(x, y) to the absolute value image abs(mi(x, y)), and the phase-corrected image p(x, y)abs(mi(x, y)) is subjected to a discrete Fourier transform to estimate the k-space data.

In this way, by repeating the processing of replacing the data portion of the measurement region in the k-space data estimated with the phase correction with the original partial k-space data Mpk(kx, ky), the k-space data Mi(kx, ky) is sequentially updated, and the unmeasured region is estimated. With the POCS method, the noise of the unmeasured region in the k-space is also estimated.

The processing of replacing the data portion of the measurement region in the k-space data estimated with the phase correction with the original measured partial k-space data Mpk(kx, ky) may be understood as, in other words, processing of fixing the data portion of the measurement region in the k-space data Mi(kx, ky) with the partial k-space data Mpk(kx, ky), replacing the data portion (portion of the replacement data) of the unmeasured region with the data of the corresponding region of the k-space data estimated by the phase correction, and updating the k-space data Mi(kx, ky).

The partial k-space data Mpk(kx, ky) and the k-space data Mi(kx, ky) are each the complex data, and the image ms(x, y) and the image mi(x, y) are each the complex image.

### Description of Issue

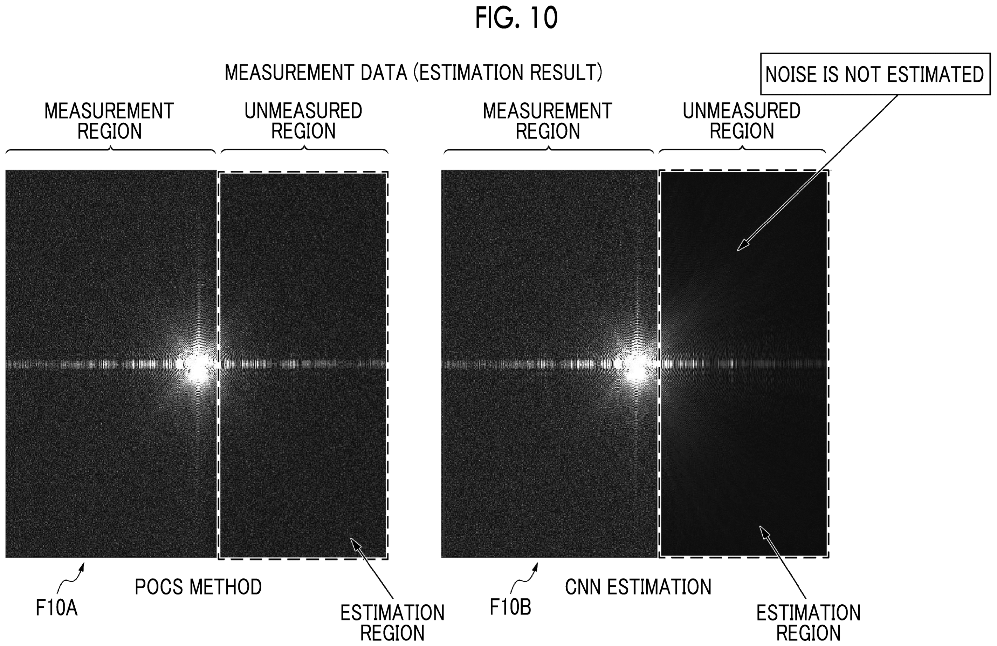

FIG. 10 is a diagram illustrating examples of the k-space data in which the unmeasured region is estimated by the POCS method from the partial measurement data and the k-space data in which the unmeasured region is estimated by the CNN estimation method. Here, k-space data F10A illustrated on the left of FIG. 10 is an estimation result of the POCS method, and k-space data F10B illustrated on the right of FIG. 10 is an estimation result of the CNN estimation method. Each region surrounded by a broken line on the right side (positive kx direction) in the k-space is an estimation region corresponding to the unmeasured region.

As can be seen by comparing two estimation regions, the noise of the unmeasured region is estimated in the POCS method, whereas the noise is not estimated in the CNN estimation method.

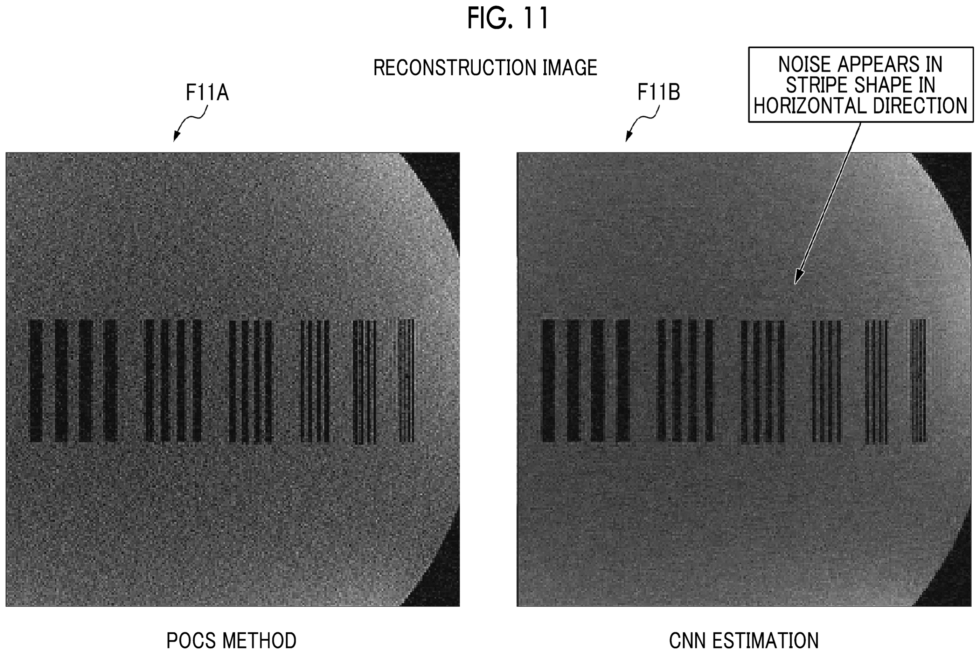

FIG. 11 is an example of a test phantom image reconstructed from each of the k-space data F10A and F10B illustrated in FIG. 10. An image F11A illustrated on the left of FIG. 11 is an image reconstructed from the k-space data F10A including the estimation result of the POCS method, and an image F11B illustrated on the right of FIG. 11 is an image reconstructed from the k-space data F10B including the estimation result of the CNN estimation method.

In the CNN estimation method, since the noise of the unmeasured region is not estimated, the image F11B having a high SNR is obtained. On the other hand, due to the asymmetry of the signal intensity caused by not estimating the noise, the noise on the image F11B appears in a stripe shape. In FIG. 10, it may be difficult to see the striped noise due to the limitation of the illustration, but the striped noise appears in a direction (horizontal direction in FIG. 9) of the unmeasured region in the k-space.

On the other hand, in the POCS method, since the noise of the unmeasured region is also estimated, the reconstruction image may include more natural point-like noise without the occurrence of the striped noise.

### First Embodiment

### Outline of Image Processing Method

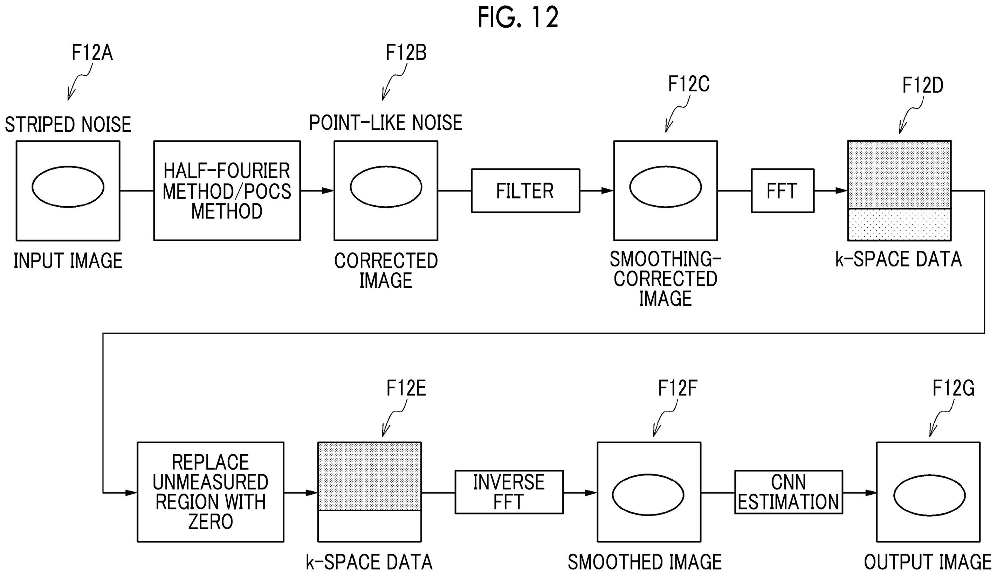

FIG. 12 is a diagram illustrating an outline of an image processing method according to a first embodiment. The image processing method according to the first embodiment is a method of reducing the striped noise of the reconstruction image by reducing the noise of the measurement region of the input data and then estimating the unmeasured region by the CNN estimation method.

First, the processor 202 acquires an input image F12A in which the striped noise has occurred. The input image is, for example, the image in which the data of the unmeasured region of the k-space is estimated by the CNN estimation method. The input image may be the image in which the data of the k-space including partial measurement data of the measurement region and zero data of the unmeasured region is reconstructed.

Next, the processor 202 acquires a corrected image F12B in which the data of the unmeasured region of the input image F12A is estimated using the half-Fourier method or the POCS method. In addition, the term "acquire" includes the concept of "generate". That is, the description of "acquire" includes the concept of acquisition by generation. In the estimation of the unmeasured region using the half-Fourier method and the POCS method, since the noise of the unmeasured region is also estimated, the noise in the corrected image F12B is point-like noise having a point-like distribution.

In addition, the processor 202 performs the smoothing filter processing on the corrected image F12B to acquire a smoothing-corrected image F12C. The smoothing-corrected image F12C has less point-like noise than the corrected image F12B.

Next, the processor 202 acquires data F12D of the k-space by performing a Fourier transform on the smoothing-corrected image F12C. The data of the measurement region of the data F12D of the k-space has less noise than the data of the measurement region of the k-space of the input image F12A.

Further, the processor 202 acquires data F12E of the k-space in which the data of the unmeasured region in the data F12D of the k-space is replaced with zero data.

Next, the processor 202 acquires a smoothed image F12F of the real space by performing an inverse Fourier transform on the data F12E of the k-space.

Finally, the processor 202 acquires an output image F12G in which the data of the unmeasured region of the smoothed image F12F is estimated by the CNN estimation method. The output image F12G is an image in which the striped noise is reduced compared to the input image F12A.

In a case in which the CNN estimation method is applied to the input image F12A instead of the half-Fourier method or the POCS method, the striped noise remains in the corrected image F12B, but it is difficult to reduce the striped noise using a general filter. Accordingly, the corrected image F12B having the point-like noise is generated by applying the half-Fourier method or the POCS method to the input image F12A. Then, by applying the smoothing filter to the corrected image F12B, the smoothing-corrected image F12C in which the noise of the measurement region of the input data is reduced can be obtained.

### Functional Configuration of Processor

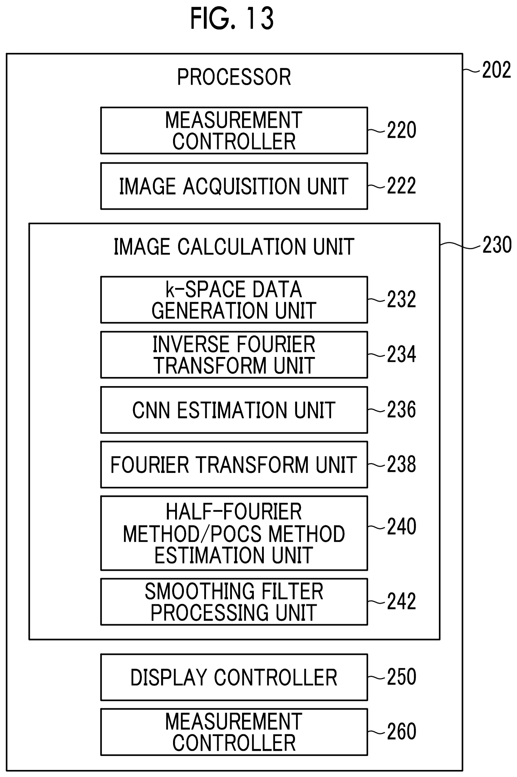

FIG. 13 is a functional block diagram of the processor 202 of the control device 200 illustrated in FIG. 1. As illustrated in FIG. 13, the processor 202 executes various programs and the trained model stored in the memory 204 to function as a measurement controller 220, an image acquisition unit 222, an image calculation unit 230, a display controller 250, and a recording controller 260.

The trained model stored in the memory 204 includes the estimation CNN (an example of a "first trained model") and the noise reduction CNN (an example of a "second trained model").

The estimation CNN is a trained model that implements the CNN estimation method. The estimation CNN may be trained to receive an input of an input reconstruction image (an example of an "input image") in which the data of the k-space including the data of the measurement region is reconstructed, and output an estimated reconstruction image (an example of an "estimation image") in which the data of the unmeasured region other than the measurement region is estimated. The estimation CNN may be trained through machine learning to receive an input of the input reconstruction image in which the data of the k-space consisting of the measurement region filled with the input measurement region data and the unmeasured region filled with zero data is reconstructed, and estimate and output the estimated reconstruction image of the real space that is reconstructed from the data of the k-space consisting of the measurement region filled with the estimated measurement region data and the unmeasured region filled with the estimated unmeasured region data. The estimation CNN may be a trained CNN that has been trained using training image sets corresponding to the patterns 1 to 4 generated by the generation method of the training image set illustrated in FIG. 8.

Further, the estimation CNN may be trained through machine learning to receive an input of the input reconstruction image in which the data of the k-space consisting of the measurement region filled with the input measurement region data and the unmeasured region filled with zero data is reconstructed, and estimate and output an estimated residual image (an example of an "estimation image") indicating a residual between the input reconstruction image and the estimated reconstruction image of the real space that is reconstructed from the data of the k-space consisting of the measurement region filled with the estimated measurement region data and the unmeasured region filled with the estimated unmeasured region data.

The noise reduction CNN may be trained to receive an input of a noise image of the real space including noise and output a noise-reduced image in which the noise is reduced. The noise reduction CNN may be trained using a ground-truth image having relatively less noise as ground-truth data and an image in which noise is added to the ground-truth image as training data. The noise may be point-like noise. A plurality of noise reduction CNNs corresponding to the noise intensity to be reduced may be stored in the memory 204.

The measurement controller 220 transmits a predetermined pulse sequence, the imaging conditions (imaging parameters) designated by the operator, and the like to the sequencer 118 (see FIG. 1) of the measurement unit 100, and controls the measurement unit 100 via the sequencer 118. In the present example, the sequence for performing the half-scan of reducing the number of steps in the phase encoding direction and/or the half-echo of reducing the number of sampling points in the frequency encoding direction is selected. In addition, the proportion of the asymmetrical unmeasured region of the k-space in a case of performing the half-scan or the half-echo is set to any of 1% to 45% by the operator, and the direction of the unmeasured region is also set by the operator.

The measurement controller 220 transmits a command to the sequencer 118 in accordance with the set conditions, and causes the measurement unit 100 to execute the pulse sequence under the control of the sequencer 118. The subject 102 is imaged by executing the pulse sequence by the measurement unit 100, and the receive coil 110 provided at the examination part of the subject 102 receives the echo signal from the subject 102. The receiver 116 executes the amplification, the detection, and the A/D conversion of the echo signal received by the receive coil 110, and transmits the digital data of the real part and the imaginary part to the control device 200 via the input/output interface 206.

The image acquisition unit 222 acquires the full sampling image from the memory 204 or the storage 205. The full sampling image is an image obtained by reconstructing the data of the k-space measured by performing full sampling with the unmeasured proportion set to 0% in the measurement unit 100, and includes the real part image and the imaginary part image.

The image calculation unit 230 includes a k-space data generation unit 232, an inverse Fourier transform unit 234, a CNN estimation unit 236, a Fourier transform unit 238, a half-Fourier method/POCS method estimation unit 240, a smoothing filter processing unit 242, and the like.

The k-space data generation unit 232 arranges the k-space data that is the digital data of the real part and the imaginary part and that is sequentially collected from the echo signal along the k-trajectory in the k-space. In a case in which the size of the FOV is set to 256 pixels × 256 pixels, the entire region of the k-space also has a size of 256 × 256, but the data of the asymmetrical unmeasured region of the entire region of the k-space by the half-scan and/or the half-echo is not collected, and the k-space data generation unit 232 acquires the partial measurement data of the measurement region excluding the unmeasured region arbitrarily set for the k-space and arranges the partial measurement data in the k-space, and fills the unmeasured region with zero data to generate the data of the k-space.

It goes without saying that, in a case in which the entire region of the k-space before the partial measurement data is arranged is filled with zero data, it is not necessary to perform the processing of filling the unmeasured region with zero data.

The inverse Fourier transform unit 234 is a unit that performs an inverse Fourier transform (inverse fast Fourier transform (FFT)) on the data of the k-space generated by the k-space data generation unit 232, and converts the data into the reconstruction image (MR image) of the real space.

The CNN estimation unit 236 is a unit that uses the estimation CNN stored in the memory 204, estimates and corrects the degradation of image quality due to the noise or the like estimated from the input image (complex image) of the estimation CNN as described with reference to FIGS. 6 and 7, and outputs the image (complex image) in which the degradation of image quality is reduced for the input complex image.

The Fourier transform unit 238 is a unit that performs a Fourier transform (FFT) on the complex image in which the degradation of image quality is reduced to generate the data of the k-space, and functions as a portion of the k-space data generation unit 232.

The half-Fourier method/POCS method estimation unit 240 is a unit that estimates data including noise of the unmeasured region by the half-Fourier method or the POCS method from the data of the asymmetrical measurement region in the k-space, and functions as a portion of the k-space data generation unit 232.

The smoothing filter processing unit 242 is a unit that performs the smoothing processing on the reconstruction image of the real space with a predetermined degree using a smoothing filter. The smoothing filter is, for example, a Gaussian filter. The smoothing filter processing unit 242 can adjust the degree of the smoothing processing by, for example, continuously or discretely adjusting the coefficients of the kernel of the Gaussian filter.

The smoothing filter processing unit 242 may perform the smoothing processing on the reconstruction image of the real space using the noise reduction CNN. The plurality of noise reduction CNNs corresponding to the noise intensity to be reduced may be stored in the memory 204. The smoothing filter processing unit 242 may perform the smoothing processing using the noise reduction CNN corresponding to the noise intensity of the input image among the plurality of noise reduction CNNs.

The display controller 250 displays the MR image calculated by the image calculation unit 230 and necessary accessory information (for example, information on the imaging conditions and the subject 102) on the display 208 (FIG. 1), and displays the MR image and the like recorded in the memory 204 on the display 208.

The recording controller 260 records the MR image with the accessory information in, for example, a medical image format of digital imaging and communications in medicine (DICOM) in the memory 204. The MR image in this case is recorded as a sum-of-squares image of the complex image.

### striped noise Reduction Method

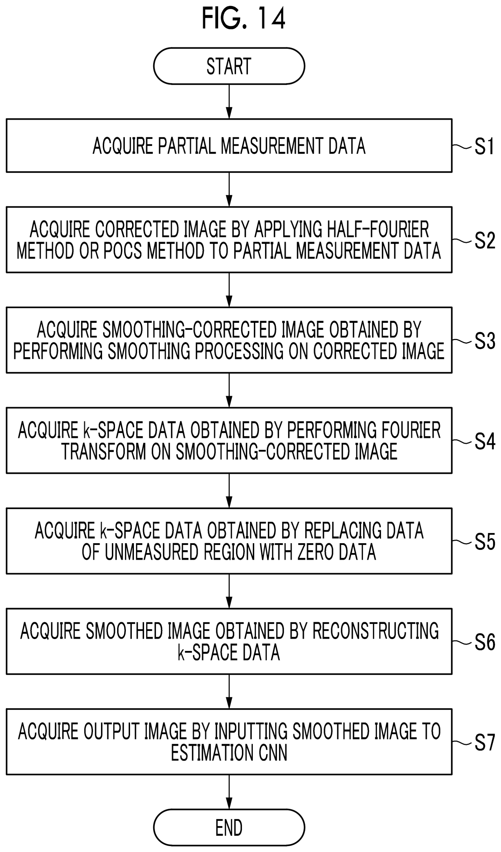

FIG. 14 is a flowchart illustrating steps of the striped noise reduction method according to the first embodiment. The striped noise reduction method is an example of an image processing method executed by a processor that converts data acquired by imaging a subject into an image. The striped noise reduction method is implemented by the processor 202 of the control device 200 executing a noise reduction program stored in the memory 204.

In step S1, the processor 202 acquires the partial measurement data. The partial measurement data is, for example, data obtained by imaging the subject 102 via the measurement unit 100 and measured in the asymmetrical measurement region on the k-space. The direction of the unmeasured region of the k-space and the proportion of the unmeasured region to the entire region of the k-space are determined in advance. Here, the measurement controller 220 causes the measurement unit 100 to execute the pulse sequence by the half-scan and/or the half-echo, and acquires the digital data of the real part and the imaginary part from the receiver 116 as the partial measurement data.

As described with reference to FIG. 12, the processor 202 may acquire the input image in which the striped noise has occurred. In this case, the Fourier transform unit 238 generates the data of the k-space by performing a Fourier transform on the input image, and acquires the partial measurement data of the measurement region.

In step S2, the processor 202 generates the corrected image of the real space by reconstructing the data of the k-space including the partial measurement data acquired in step S1. Here, first, the k-space data generation unit 232 arranges the partial measurement data in the measurement region of the k-space, and fills the unmeasured region with zero data to generate the data of the k-space. Next, the half-Fourier method/POCS method estimation unit 240 estimates the data of the unmeasured region from the data of the k-space generated by the half-Fourier method or the POCS method. Further, the inverse Fourier transform unit 234 performs an inverse Fourier transform on the data of the k-space including the partial measurement data of the measurement region and the estimated data of the unmeasured region to convert the data into the corrected image.

In step S3, the processor 202 acquires the smoothing-corrected image in which the smoothing processing is performed on the corrected image acquired in step S2. Here, in the smoothing filter processing unit 242, the smoothing filter processing is performed on the corrected image to generate the smoothing-corrected image.

In step S4, the processor 202 acquires the data of the k-space in which the smoothing-corrected image acquired in step S3 is subjected to a Fourier transform. Here, in the Fourier transform unit 238, the smoothing-corrected image is subjected to a Fourier transform to generate the smoothing-corrected data of the k-space.

In step S5, the processor 202 acquires the data of the k-space in which the data of the unmeasured region of the data of the k-space acquired in step S4 is replaced with zero data. Here, the k-space data generation unit 232 replaces the data of the unmeasured region of the smoothing-corrected data of the k-space with zero data.

In step S6, the processor 202 acquires the smoothed image of the real space in which the data of the k-space acquired in step S5 is reconstructed. Here, the inverse Fourier transform unit 234 performs an inverse Fourier transform on the data of the k-space acquired in step S5 to convert the data into the smoothed image.

In step S7, the processor 202 inputs the smoothed image acquired in step S6 to the estimation CNN to acquire the output image. The estimation CNN is, for example, a CNN that receives an input of the input reconstruction image, and estimates and outputs the estimated reconstruction image. Here, the CNN estimation unit 236 inputs the smoothed image to the estimation CNN, and acquires the output image output from the estimation CNN.

The estimation CNN may be a CNN that receives an input of the input reconstruction image, and estimates and outputs the estimated residual image. In this case, the CNN estimation unit 236 may acquire the output image from the smoothed image input to the estimation CNN and the estimated residual image output from the estimation CNN.

The output image is the image in which the striped noise is reduced.

### Second Embodiment

### Description of Issue: Degradation in Resolution

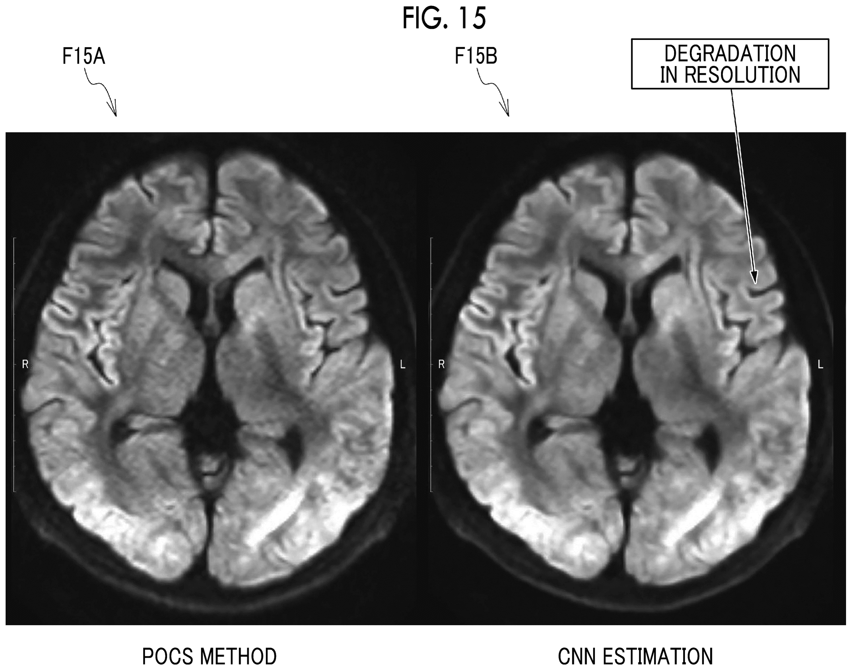

FIG. 15 is a diagram illustrating the degradation in resolution of the MR image by the CNN estimation method. F15A of FIG. 15 illustrates the MR image in a case in which the data of the unmeasured region is estimated by the POCS method. In addition, F15B of FIG. 15 illustrates the MR image in a case in which the data of the unmeasured region is estimated by the CNN estimation method. F15A and F15B are head diffusion-weighted images in which the unmeasured proportion is 40%. As illustrated in FIG. 15, the MR image using the CNN estimation method has a degraded resolution as compared with the MR image using the POCS method.

### Outline of Image Processing Method

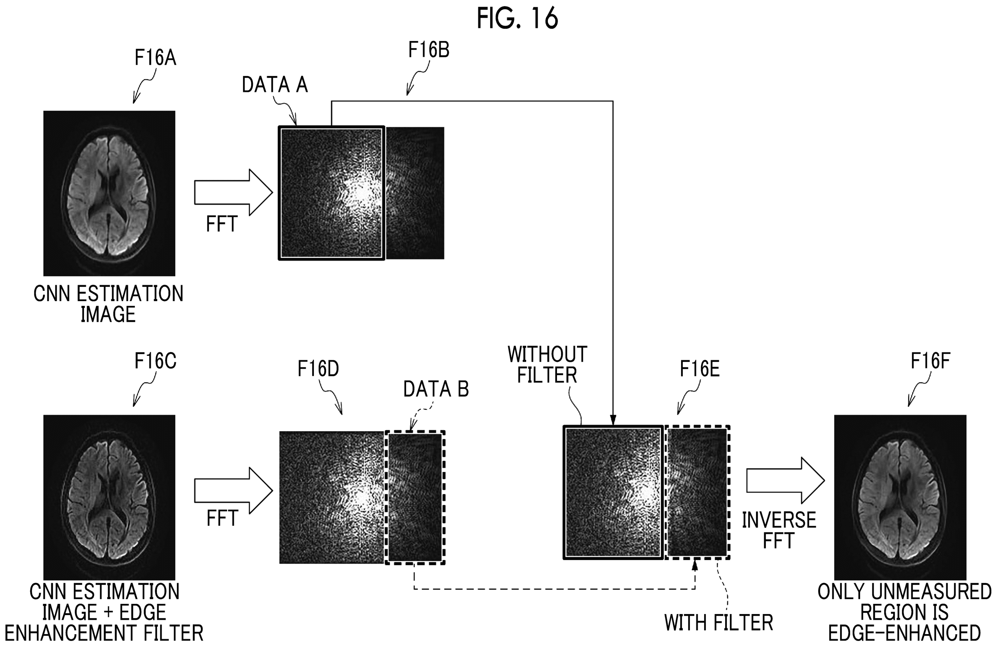

The image processing method according to the second embodiment obtains the MR image in which the resolution of the data of the unmeasured region is improved while suppressing the increase in noise of the data of the measurement region of the MR image estimated by the CNN estimation method. FIG. 16 is a diagram illustrating an outline of an image processing method according to a second embodiment.

F16A of FIG. 16 illustrates an example of the CNN estimation image that is the reconstruction image in which the data of the unmeasured region is estimated by the CNN estimation method from the partial measurement data of the asymmetrical measurement region on the k-space. In addition, F16B of FIG. 16 illustrates the data of the k-space that is a result of performing a Fourier transform on the CNN estimation image of F16A.

F16C of FIG. 16 illustrates an edge enhancement estimation image that is a result of performing edge enhancement filter processing on the CNN estimation image of F16A. In addition, F16D of FIG. 16 illustrates the data of the k-space that is a result of performing a Fourier transform on the edge enhancement estimation image of F16C.

F16E of FIG. 16 illustrates the data of the k-space in which data A that is the data of the measurement region in the data of the k-space of F16B and data B that is the data of the unmeasured region in the data of the k-space of F16D are combined. That is, the data of the k-space of F16E is data in which the data A of the measurement region to which the edge enhancement filter is not applied and the data B of the unmeasured region to which the edge enhancement filter is applied are combined. The k-space data of F16E is synonymous with the k-space data of F16B in which the data of the unmeasured region is replaced with the data B, and the k-space data of F16D in which the data of the measurement region is replaced with the data A.

F16F of FIG. 16 illustrates the MR image that is the output image in which the data of the k-space of F16E is subjected to an inverse Fourier transform. In the MR image of F16F, only the data of the unmeasured region is enhanced. Accordingly, in the MR image of F16F, the increase in noise of the data of the measurement region is suppressed, and the resolution of the data of the unmeasured region is improved.

### Functional Configuration of Processor

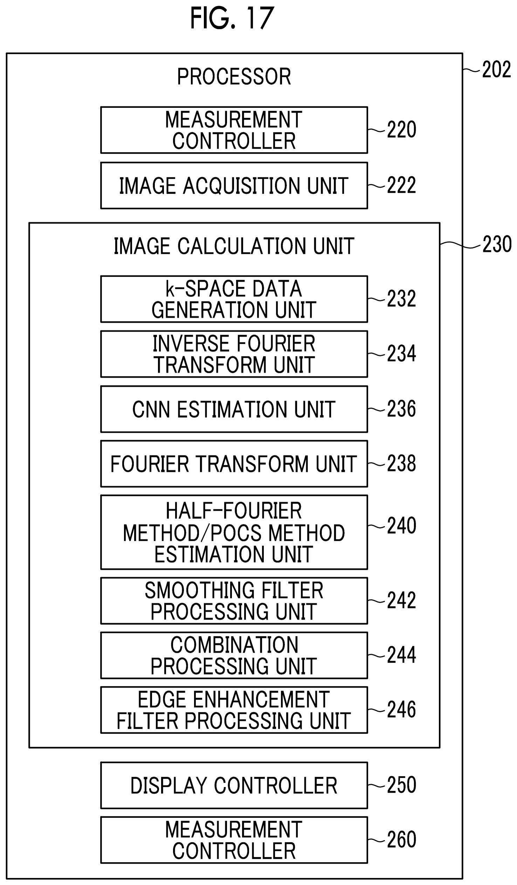

FIG. 17 is a functional block diagram of the processor 202 according to the second embodiment. In the configuration illustrated in FIG. 17, the same or similar elements as those illustrated in FIG. 13 are denoted by the same reference numerals, and duplicate descriptions will be omitted. As illustrated in FIG. 17, the processor 202 includes a combination processing unit 244 and an edge enhancement filter processing unit 246.

The combination processing unit 244 is a unit that combines the data of the k-space, and functions as a portion of the k-space data generation unit 232.

The edge enhancement filter processing unit 246 is a unit that performs edge enhancement processing on the reconstruction image of the real space with a predetermined intensity using the edge enhancement filter. The edge enhancement filter is, for example, unsharp mask processing. The edge enhancement filter processing unit 246 can adjust the strength of the edge enhancement by continuously or discretely adjusting the strength of the unsharp mask processing, for example.

### Generation Method of MR Image

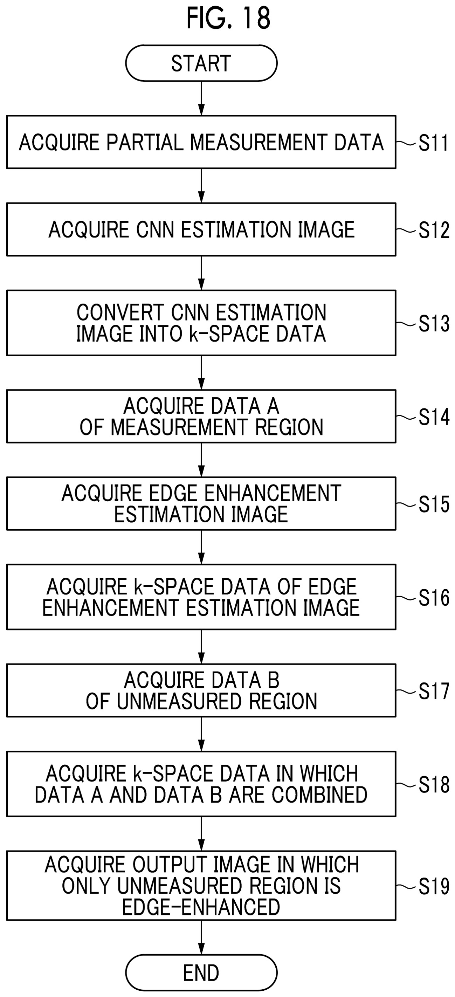

FIG. 18 is a flowchart illustrating steps of the generation method of the MR image according to the second embodiment. The generation method of the MR image is implemented by the processor 202 of the control device 200 executing a program for generating the MR image stored in the memory 204.

The processing of step S11 is the same as the processing of step S1 of FIG. 14.

In step S12, the processor 202 acquires the CNN estimation image from the partial measurement data acquired in step S11. The processor 202 acquires the CNN estimation image using the estimation CNN stored in the memory 204. The estimation CNN is, for example, a CNN that receives an input of the input reconstruction image, and estimates and outputs the estimated reconstruction image. Here, the k-space data generation unit 232 generates the data of the k-space by arranging the partial measurement data in the measurement region of the k-space and filling the unmeasured region with zero data. The inverse Fourier transform unit 234 performs an inverse Fourier transform on the data of the k-space to convert the data into the MR image of the real space. The CNN estimation unit 236 inputs the MR image converted by the inverse Fourier transform unit 234 to the estimation CNN, and acquires the CNN estimation image output from the estimation CNN.

The estimation CNN may be a CNN that receives an input of the input reconstruction image, and estimates and outputs the estimated residual image. In this case, the CNN estimation unit 236 may acquire the CNN estimation image from the MR image input to the estimation CNN and the estimated residual image output from the estimation CNN.

In step S12, the processor 202 may acquire the output image to which the striped noise reduction method according to the first embodiment is applied. That is, the processor 202 may perform the processing of steps S2 to S7 of FIG. 14 on the partial measurement data acquired in step S11 to acquire the output image as the CNN estimation image. As a result, the CNN estimation image to which the striped noise is reduced can be acquired.

In step S13, the processor 202 converts the CNN estimation image acquired in step S12 into the data of the k-space. Here, the Fourier transform unit 238 generates the data of the k-space by performing a Fourier transform on the CNN estimation image.

In step S14, the processor 202 acquires the data A (an example of "first measurement region data") of the measurement region of the k-space. Here, the combination processing unit 244 acquires, as the data A, the entire data of the measurement region in the data of the k-space converted in step S13.

In step S15, the processor 202 acquires the edge enhancement estimation image (an example of an "edge-enhanced image"). Here, the edge enhancement filter processing unit 246 performs the edge enhancement filter processing on the CNN estimation image acquired in step S12 to generate the edge enhancement estimation image.

In step S16, the processor 202 acquires the data of the k-space of the edge enhancement estimation image acquired in step S15. Here, the Fourier transform unit 238 performs a Fourier transform on the edge enhancement estimation image to generate the data of the k-space.

In step S17, the processor 202 acquires the data (an example of "first unmeasured region data") of the unmeasured region in the data of the k-space acquired in step S16. Here, the combination processing unit 244 acquires the entire data of the unmeasured region in the data of the k-space converted in step S16 as the data B.

In step S18, the processor 202 acquires the k-space data obtained by combining the data A acquired in step S14 and the data B acquired in step S17. Here, the combination processing unit 244 generates the data of the k-space by filling the measurement region of the k-space with the data A and filling the unmeasured region of the k-space with the data B.

Finally, in step S19, the processor 202 acquires the output image (an example of a "resolution-improved image") in which only the data of the unmeasured region is edge-enhanced. Here, the inverse Fourier transform unit 234 performs an inverse Fourier transform on the data of the k-space acquired in step S18 to reconstruct the MR image that is the output image. In the MR image acquired in this way, the noise of the data of the measurement region is suppressed, the edge of the data of the unmeasured region is enhanced, and the resolution is improved.

In a case in which the output image in which the noise reduction method according to the first embodiment is applied is acquired as the CNN estimation image in step S12, the output image acquired in step S19 is an image in which the striped noise is further reduced.

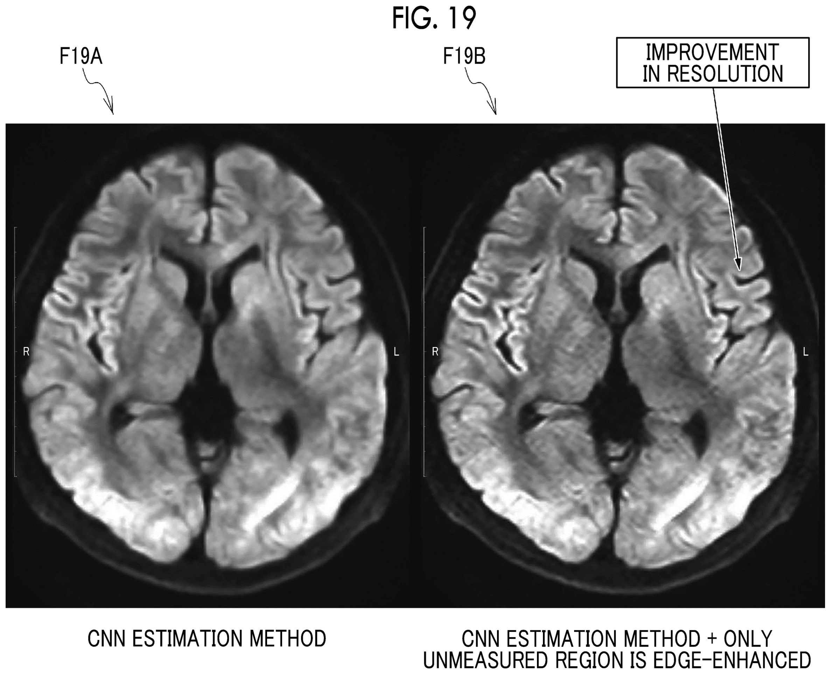

FIG. 19 is a diagram illustrating the improvement in resolution. F19A of FIG. 19 illustrates the MR image in a case in which the data of the unmeasured region is estimated by the CNN estimation method, and is the head diffusion-weighted image in which the unmeasured proportion is 40%. In addition, F19B of FIG. 19 illustrates the MR image generated by the generation method of the MR image according to the second embodiment, and is the MR image in which only the data of the unmeasured region of the MR image of F20A is subjected to the edge enhancement processing. As illustrated in FIG. 19, the resolution of the MR image of F19B is improved.

The edge enhancement filter processing unit 246 may acquire the strength of the edge enhancement in the edge enhancement filter processing based on the average value of the absolute values of the data of the measurement region that is symmetric to the unmeasured region of the k-space in the data A of the measurement region of the k-space and the average value of the absolute values of the data B of the unmeasured region. For example, the edge enhancement filter processing unit 246 may determine the strength of the edge enhancement to the strength at which the average value of the absolute values of the data of the measurement region that is symmetric to the unmeasured region and the average value of the absolute values of the data B are at the same level. Here, "approximately equal" is preferably within ±5%, more preferably within ±3%, and still more preferably within ±1%.

In addition, the edge enhancement filter processing unit 246 may receive the input of the strength from the operator and perform the edge enhancement filter processing with the received strength. The processor 202 may display the output image and a slider bar for adjusting the strength of the edge enhancement filter processing on the display 208. In this case, the strength is determined in accordance with the position of the slider of the slider bar. As a result, the operator can change the position of the slider of the slider bar while visually recognizing the output image to adjust the strength of the edge enhancement filter processing to appropriate strength.

### Third Embodiment

### Outline of Image Processing Method

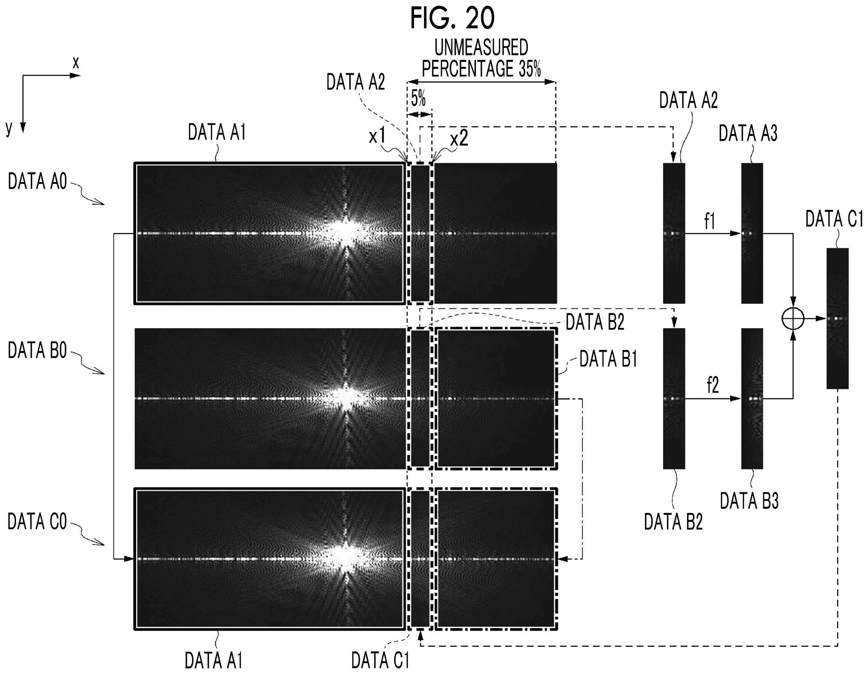

The image processing method according to the third embodiment obtains the MR image in which the data of the measurement region to which the edge enhancement is not applied and the data of the unmeasured region to which the edge enhancement is applied are smoothly connected in the MR image estimated by the CNN estimation method. FIG. 20 is a diagram illustrating the generation method of the MR image according to the third embodiment.

Data A0 illustrated in FIG. 20 is data of the k-space that is a result of performing a Fourier transform on the CNN estimation image in which the data of the unmeasured region is estimated by the CNN estimation method from the partial measurement data of the asymmetrical measurement region on the k-space. In the k-space having the data A0, the unmeasured region is present in the right direction (x direction of FIG. 20) of the k-space, and the unmeasured proportion is 35%. The data A0 includes data A1 and data A2. The data A1 is data of the measurement region in the data A0. The data A2 is data of an adjacent region that is a region from a position x1 of a boundary between the measurement region and the unmeasured region to a position x2 that is 5% of the data size in the x direction away from the position x1 in the data of the unmeasured region of the data A0. In FIG. 20, the x direction means the kx axis direction.

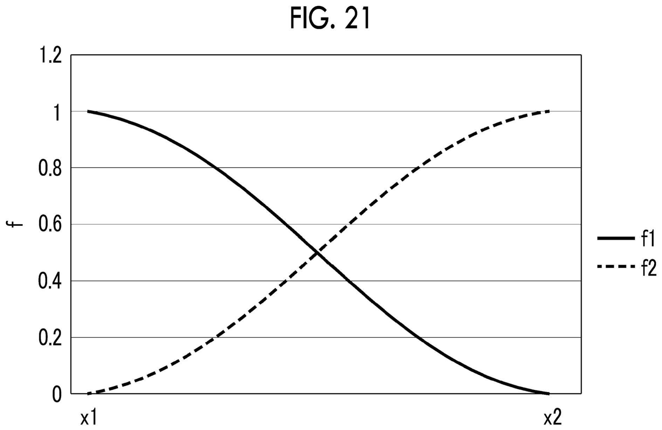

Data A3 illustrated in FIG. 20 is data that is a result of multiplying the data A2 by a Hanning window function f1. FIG. 21 is a graph illustrating the Hanning window function. As illustrated in FIG. 21, the Hanning window function f1 has a value of "1" at the position x1, the value gradually increases as the distance from the position x2 decreases, and the value reaches "0" at the position x2. That is, the Hanning window function f1 is a function that converges from x1 to x2.

Data B0 illustrated in FIG. 20 is data of the k-space that is a result of performing the edge enhancement processing on the CNN estimation image before a Fourier transform of the data A0 and performing a Fourier transform. The data B0 includes data B1 and data B2. The data B1 is data other than the data of the adjacent region in the data of the unmeasured region. The data B2 is data of the adjacent region.

Data B3 illustrated in FIG. 20 is data that is a result of multiplying the data B2 by a Hanning window function f2. As illustrated in FIG. 21, the Hanning window function f2 has a value of "0" at the position x1, the value gradually increases as the distance from the position x2 decreases, and the value reaches "1" at the position x2. That is, the Hanning window function f2 is a function that converges from x2 to x1.

Data C1 illustrated in FIG. 20 is data that is a result of adding the data A3 and the data B3.

Data C0 illustrated in FIG. 20 is data of the k-space that is a result of combining the data A1, the data C1, and the data B1. In the data C0, the data A1 of the measurement region to which the edge enhancement filter is not applied and the data B1 of the unmeasured region to which the edge enhancement filter is applied are smoothly connected through the data C1 of the adjacent region in which the intensity of the edge enhancement gradually changes.

### Generation Method of MR Image

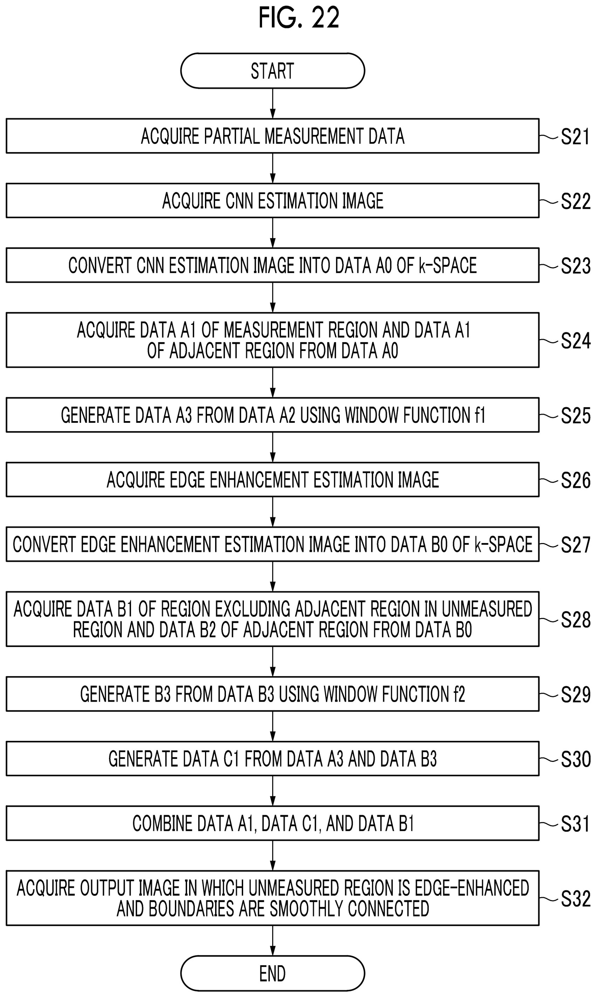

FIG. 22 is a flowchart illustrating steps of the generation method of the MR image according to the third embodiment. The processing of steps S21 and S22 is the same as the processing of steps S11 and S12 illustrated in FIG. 18. In step S12, the processor 202 may acquire, as the CNN estimation image, the output image obtained by applying the noise reduction method according to the first embodiment.

In step S23, the processor 202 converts the CNN estimation image acquired in step S22 into the data A0 of the k-space. Here, the Fourier transform unit 238 performs a Fourier transform on the CNN estimation image to convert the CNN estimation image into the data A0 of the k-space.

In step S24, the processor 202 acquires the data A1 of the measurement region and the data A2 of the adjacent region from the data A0 of the k-space converted in step S23. Here, the combination processing unit 244 acquires, as the data A1, the entire data of the measurement region in the data A0 of the k-space converted in step S23. In addition, the combination processing unit 244 acquires the entire data of the adjacent region that is adjacent to the measurement region and extends a predetermined distance from the measurement region in the data of the unmeasured region (an example of "second unmeasured region data") from the data A0 of the k-space converted in step S23 as the data A2 (an example of "first adjacent region data"). The adjacent region is a region from the position x1 of the boundary between the measurement region and the unmeasured region to the position x2 that is 5% of the data size in the x direction away from the position x1. A width of the adjacent region in the x direction is not limited to 5% of the data size, and can be determined as appropriate.

In step S25, the processor 202 generates the data A3 in which the weight of the data A2 is gradually decreased as a distance from the measurement region increases. Here, the combination processing unit 244 multiplies the data A2 by the Hanning window function f1 (an example of a "first window function", see FIG. 21) to generate the data A3.

In step S26, the processor 202 acquires the edge enhancement estimation image. Here, the edge enhancement filter processing unit 246 performs the edge enhancement filter processing on the CNN estimation image acquired in step S22 to generate the edge enhancement estimation image.

In step S27, the processor 202 converts the edge enhancement estimation image acquired in step S26 into the data B0 of the k-space. Here, the Fourier transform unit 238 performs a Fourier transform on the edge enhancement estimation image to convert the edge enhancement estimation image into the data B0 of the k-space.

In step S28, the processor 202 acquires the data B1 of the region excluding the adjacent region in the unmeasured region and the data B2 of the adjacent region from the data B0 of the k-space converted in step S27. Here, the combination processing unit 244 acquires the entire data of the region excluding the adjacent region in the unmeasured region in the data B0 of the k-space converted in step S27, as the data B1 (an example of "first unmeasured region data other than the adjacent region"). In addition, the combination processing unit 244 acquires the entire data of the adjacent region in the data B0 of the k-space converted in step S27, as the data B2 (an example of "second adjacent region data").

In step S29, the processor 202 generates the data B3 in which the weight of the data B2 is gradually increased as a distance from the measurement region increases. Here, the combination processing unit 244 multiplies the data B2 by the Hanning window function f2 (an example of a "second window function", see FIG. 21) to generate the data B3.

In step S30, the processor 202 generates the data C1 from the data A3 and the data B3. Here, the combination processing unit 244 adds the data A3 and the data B3 to generate the data C1 (an example of "third adjacent region data").

In step S31, the processor 202 generates the data of the k-space in which the data A1 acquired in step S24, the data C1 generated in step S30, and the data B1 acquired in step S28 are combined. Here, the combination processing unit 244 generates the data of the k-space by filling the measurement region of the k-space with the data A1, filling the adjacent region of the k-space with the data C1, and filling the unmeasured region of the k-space excluding the adjacent region with the data B1. In the data of the k-space, the data of the measurement region in which the increase in noise is suppressed and the data of the unmeasured region in which the edges are enhanced and the resolution is improved are smoothly connected through the data of the adjacent region in which the intensity of the edge enhancement gradually changes.

Finally, in step S22, the processor 202 acquires the output image in which the edge of the data of the unmeasured region is enhanced and the boundaries are smoothly connected. Here, the inverse Fourier transform unit 234 performs an inverse Fourier transform on the data of the k-space acquired in step S21 to reconstruct the MR image that is the output image. In the MR image acquired in this way, the increase in noise of the data of the measurement region is suppressed, the resolution of the data of the unmeasured region is improved, and the measurement region and the unmeasured region are smoothly connected by the data of the adjacent region.

As described above, with the generation method of the MR image according to the third embodiment, it is possible to generate the MR image in which the boundary between the measurement region and the unmeasured region is inconspicuous.

### Processor

In the embodiments of the present disclosure, each processing is executed by any computer. Further, any computer may execute the processing by a processor, a program, or a combination thereof. Any computer may be a general-purpose computer, a computer for a specific purpose, a system such as a workstation, or other hardware components capable of executing a program.

The processor may be configured by one or a plurality of hardware components, and the types of hardware are not limited. The processor may be configured by, for example, a central processing unit (CPU), a micro processing unit (MPU), a programmable logic device such as a field programmable gate array (FPGA), a dedicated circuit for executing specific processing, such as an application specific integrated circuit (ASIC), or hardware such as a graphics processing unit (GPU) or a neural processing unit (NPU).

The processor includes each unit or each means that executes various types of processing in the embodiment of the present disclosure. The type of hardware may be a combination of different types of hardware components. In a case in which the plurality of types of hardware components are configured to execute one or a plurality of processes of a certain processor, the plurality of types of hardware components may be present in devices physically separated from each other or may be present in the same device. Furthermore, in any of the embodiments, the order of each process performed by the processor is not limited to the above-described order, and may be changed as appropriate. The hardware is configured by an electric circuit (circuitry) in which circuit elements, such as semiconductor elements, are combined, or the like.

Furthermore, the embodiment of the present disclosure may be implemented by hardware, software, firmware, microcode, or a combination thereof. Software, firmware, and microcode are configured by a program. The program may be, for example, a group of program modules, and each function thereof may be implemented by a processor configured to execute each function. The program may be a program code or a plurality of code segments stored in one or more non-transitory computer-readable media (for example, a storage medium and other storages). The program may be stored in the plurality of non-transitory computer-readable media present in devices physically separated from each other. The program code or the code segment may represent any combination of procedures, functions, subprograms, routines, subroutines, modules, software packages, classes, or commands, data structures, or program statements. The program code or the code segment may be connected to another code segment or a hardware circuit by transmitting and receiving information, data, an argument, a parameter, or a content of a memory.

### Example of Application to Program and Program Product

The image processing method in the embodiments of the present disclosure may be configured as a program or a program product for causing a processor or a computer including the processor to implement functions of each step. The program product is a computer-readable medium that is a tangible, non-transitory information storage medium on which a program is recorded.

A program for causing a computer to achieve some or all of processing functions of the control device 200 according to the embodiments of the present disclosure can be recorded on a computer-readable medium that is an optical disk, a magnetic disk, a semiconductor memory, or another tangible, non-transitory storage medium, and the program can be provided through the storage medium.

Alternatively to the aspect of providing the program stored on such a tangible, non-transitory computer-readable medium, the program signal may be provided as a download service via a communication network such as the Internet.

Further, some or all of the processing functions in the control device 200 may be implemented by cloud computing, or can be provided as software as a service (SaaS).

### Others

The processor may multiply the first adjacent region data by a first window function having a value of 1 at a position adjacent to the measurement region and a value of 0 at a position at the predetermined distance from the measurement region, multiply the second adjacent region data by a second window function having a value of 0 at a position adjacent to the measurement region and a value of 1 at a position at the predetermined distance from the measurement region, and generate the third adjacent region data by adding the multiplied first adjacent region data and the multiplied second adjacent region data.

The first window function and the second window function may each be a Hanning window.

The processor may acquire the intensity of the edge enhancement filter processing, and generate the fifth reconstruction image in which the edge enhancement filter processing is performed with the acquired intensity.

The processor may acquire the intensity based on the average value of the absolute values of the measurement region data of the symmetric region that is symmetric to the unmeasured region of the k-space in the first measurement region data and the average value of the absolute values of the first unmeasured region data.

The processor may receive the input of the intensity from the operator.

The configurations described in each of the above-described embodiments and the features described in the modification examples may be used in appropriate combinations, and some features may be substituted. The present disclosure is not limited to the embodiments described above, and various modifications can be made without departing from the gist of the technical idea of the present disclosure.

### Explanation of References

10: MRI apparatus
100: measurement unit
102: subject
103: bed
104: static field magnet
106: gradient coil
108: RF coil
110: receive coil
112: radio frequency magnetic field generator
114: gradient magnetic field power supply
116: receiver
118: sequencer
200: control device
202: processor
204: memory
205: storage
206: input/output interface
208: display
210: operation unit
220: measurement controller
222: image acquisition unit
230: image calculation unit
232: k-space data generation unit
234: inverse Fourier transform unit
236: CNN estimation unit
238: Fourier transform unit
240: half-Fourier method/POCS method estimation unit
242: smoothing filter processing unit
244: combination processing unit
246: edge enhancement filter processing unit
250: display controller
260: recording controller
add1: addition layer
Conv1 to 9: convolutional layer
f1: Hanning window function
f2: Hanning window function
F2A: full measurement data
F2B: image
F4A: k-space
F4B: k-space
F4C: k-space
F4D: k-space
F7A: complex image
F7B: complex image
F8A: image generation process
F8B: image generation process
F8C: image generation process
F8D: image generation process
F10A: k-space data
F10B: k-space data
F11A: image
F11B: image
F12A: input image
F12B: corrected image
F12C: smoothing-corrected image
F12D: data of k-space
F12E: data of k-space
F12F: smoothed image
F12G: output image
F15A: MR image
F15B: MR image
F16A: CNN estimation image
F16B: data of k-space
F16C: edge enhancement estimation image
F16D: data of k-space
F16E: data of k-space
F16F: MR image
F19A: MR image
F19B: MR image
FKt: full measurement data
Fmt: full measurement image
in1: input layer
PKt: partial measurement data
Pmt: partial measurement image
Pmu: partial measurement image
PPmu: estimation image
Relu1 to 8: activation layer
S1 to S7: step of striped noise reduction method
S11 to S19: step of generation method of MR image
S21 to S32: step of generation method of MR image
x1: position
x2: position

## Claims

1. A magnetic resonance imaging apparatus comprising:
a processor that converts data acquired by imaging a subject into an image,
wherein the processor
acquires partial measurement data of an asymmetrical measurement region of a k-space,
estimates data of an unmeasured region other than the measurement region of the k-space by applying a half-Fourier method or a projection onto convex sets (POCS) method to the partial measurement data,
acquires a corrected image in which data of the k-space including the partial measurement data of the measurement region and the estimated data of the unmeasured region is reconstructed,
acquires a smoothing-corrected image obtained by performing smoothing filter processing on the corrected image,
acquires smoothing-corrected data of the k-space obtained by performing a Fourier transform on the smoothing-corrected image,
replaces the data of the unmeasured region in the smoothing-corrected data of the k-space with zero data,
acquires a smoothed image in which the data of the k-space including the smoothing-corrected data of the measurement region and the zero data of the unmeasured region is reconstructed, and
estimates an output image by inputting the smoothed image to a first trained model that has been trained to receive an input of an input reconstruction image in which the data of the k-space including data of the measurement region is reconstructed and output an estimated reconstruction image in which the data of the unmeasured region is estimated.

2. The magnetic resonance imaging apparatus according to claim 1,
wherein the processor uses, for the smoothing filter processing, a second trained model that has been trained to receive an input of a noise image having noise and output a noise-reduced image in which the noise is reduced.

3. The magnetic resonance imaging apparatus according to claim 2,
wherein the second trained model has been trained using a ground-truth image having relatively less noise as ground-truth data and an image in which the noise is added to the ground-truth image as training data.

4. The magnetic resonance imaging apparatus according to any one of claims 1 to 3,
wherein the processor acquires the partial measurement data by performing a Fourier transform on a reconstruction image having striped noise.

5. The magnetic resonance imaging apparatus according to any one of claims 1 to 4,
wherein the first trained model is a trained model that has been trained through machine learning to receive an input of an input image in which the data of the k-space consisting of the measurement region filled with input measurement region data and the unmeasured region filled with zero data is reconstructed, and estimate and output the estimated reconstruction image of the real space reconstructed from the data of the k-space consisting of the measurement region filled with estimated measurement region data and the unmeasured region filled with estimated unmeasured region data.

6. The magnetic resonance imaging apparatus according to any one of claims 1 to 4,
wherein the first trained model is a trained model that has been trained through machine learning to receive an input of an input image in which the data of the k-space consisting of the measurement region filled with input measurement region data and the unmeasured region filled with zero data is reconstructed, and estimate and output an estimated residual image indicating a residual between the input image and the estimated reconstruction image of the real space reconstructed from the data of the k-space consisting of the measurement region filled with estimated measurement region data and the unmeasured region filled with estimated unmeasured region data.

7. The magnetic resonance imaging apparatus according to any one of claims 1 to 6,
wherein the processor
acquires first measurement region data of the measurement region of the k-space obtained by performing a Fourier transform on the output image,
generates an edge-enhanced image obtained by performing edge enhancement filter processing on the output image,
acquires first unmeasured region data of the unmeasured region of the k-space obtained by performing a Fourier transform on the edge-enhanced image, and
generates a resolution-improved image by reconstructing the data of the k-space including the first measurement region data and the first unmeasured region data.

8. The magnetic resonance imaging apparatus according to claim 7,
wherein the processor
acquires a first adjacent region data corresponding to an adjacent region that is adjacent to the measurement region and extends a predetermined distance from the measurement region in second unmeasured region data of the unmeasured region of the k-space obtained by performing a Fourier transform on the output image,
acquires second adjacent region data corresponding to the adjacent region in the first unmeasured region data,
generates third adjacent region data from the first adjacent region data of which a weight is gradually decreased as a distance from the measurement region increases and the second adjacent region data of which a weight is gradually increased as the distance from the measurement region increases, and
generates the resolution-improved image by reconstructing the data of the k-space including the first measurement region data, the third adjacent region data, and the first unmeasured region data other than the adjacent region.

9. An image processing method executed by a processor that converts data acquired by imaging a subject into an image, the image processing method comprising:
acquiring partial measurement data of an asymmetrical measurement region of a k-space;
estimating data of an unmeasured region other than the measurement region of the k-space by applying a half-Fourier method or a projection onto convex sets (POCS) method to the partial measurement data;
acquiring a corrected image in which data of the k-space including the partial measurement data of the measurement region and the estimated data of the unmeasured region is reconstructed;
acquiring a smoothing-corrected image obtained by performing smoothing filter processing on the corrected image;
acquiring smoothing-corrected data of the k-space obtained by performing a Fourier transform on the smoothing-corrected image;
replacing the data of the unmeasured region in the smoothing-corrected data of the k-space with zero data;
acquiring a smoothed image in which the data of the k-space including the smoothing-corrected data of the measurement region and the zero data of the unmeasured region is reconstructed; and
estimating an output image by inputting the smoothed image to a first trained model that has been trained to receive an input of an input reconstruction image in which the data of the k-space including data of the measurement region is reconstructed and output an estimated reconstruction image in which the data of the unmeasured region is estimated.

10. A non-transitory computer-readable recording medium on which a program for causing a computer to execute the image processing method according to claim 9 is recorded.
